(19) **Europäisches Patentamt / European Patent Office / Office européen des brevets**

(11) **EP 4 593 083 A1**

(12) **EUROPEAN PATENT APPLICATION**
published in accordance with Art. 153(4) EPC

(43) Date of publication:
**30.07.2025 Bulletin 2025/31**

(21) Application number: **23934346.0**

(22) Date of filing: **23.04.2023**

(51) International Patent Classification (IPC):
**H01L 27/12** (2006.01)     **G09G 3/3233** (2016.01)

(52) Cooperative Patent Classification (CPC):
**G09G 3/3233; H10D 86/00**

(86) International application number:
**PCT/CN2023/090129**

(87) International publication number:
**WO 2024/221140 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Boe Technology Group Co., Ltd.**
  **Beijing 100015 (CN)**
• **Beijing BOE Technology Development Co., Ltd.**
  **Beijing 100176 (CN)**

(72) Inventors:
• **XU, Pan**
  **Beijing 100176 (CN)**
• **HAN, Ying**
  **Beijing 100176 (CN)**
• **XU, Cheng**
  **Beijing 100176 (CN)**

(74) Representative: **CMS Cameron McKenna Nabarro Olswang LLP**
  **Cannon Place**
  **78 Cannon Street**
  **London EC4N 6AF (GB)**

(54) **DISPLAY SUBSTRATE AND DISPLAY APPARATUS**

(57)     A display substrate and a display apparatus. The display substrate comprises: a base (10) and a plurality of sub-pixels provided on the base (10), wherein at least one sub-pixel comprises a pixel circuit, which comprises a third transistor (T3) and a plurality of transistors connected to the third transistor (T3); active patterns of at least two transistors connected to a gate electrode of the third transistor (T3) are first active layers (A1); active patterns of at least two transistors connected to any one of a first electrode and a second electrode of the third transistor (T3) and an active layer of the third transistor (T3) are second active layers (A2); the first active layers (A1) and the second active layers (A2) are arranged in a first direction (D1) and at least partially extend in a second direction (D2); and the length of the first active layers (A1) in the second direction (D2) is greater than the length of the second active layers (A2) in the second direction (D2).

FIG. 5

EP 4 593 083 A1

## Description

Technical Field

The present disclosure relates to, but is not limited to, the field of display technologies, and more particularly, to a display substrate and a display apparatus.

Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, very high response speed, lightness and thinness, flexibility, and low cost. With constant development of display technologies, a flexible display apparatus (Flexible Display) in which an OLED or a QLED is used as a light emitting device and signal control is performed through a Thin Film Transistor (TFT for short) has become a mainstream product in the field of display at present.

Summary

The following is a summary of subject matter described in the present disclosure in detail. This summary is not intended to limit the protection scope of claims.
In a first aspect, the present disclosure provides a display substrate including: a base substrate and a plurality of sub-pixels arranged on the base substrate, and at least one sub-pixel includes: a pixel circuit, which includes: a third transistor and a plurality of transistors connected with the third transistor; a transistor includes an active pattern, and active patterns of at least two transistors connected with a gate electrode of the third transistor are of an integral structure and are a first active layer; active patterns of at least two transistors connected with any one of a first electrode and a second electrode of the third transistor and an active pattern of the third transistor are of an integral structure and are a second active layer;

the first active layer and the second active layer are arranged along a first direction, and at least part of the first active layer and the second active layer extends along a second direction, and the first direction intersects with the second direction; and

a length of the first active layer along the second direction is greater than a length of the second active layer along the second direction.

In an exemplary implementation, a plurality of transistors connected to the third transistor include a first transistor, a second transistor, a fourth transistor, and a fifth transistor, and the first transistor to the fifth transistor are N-type transistors;

a second electrode of the first transistor is electrically connected to a second electrode of the third transistor, a second electrode of the second transistor and a second electrode of the fourth transistor are electrically connected to a gate electrode of the third transistor, respectively, and a second electrode of the fifth transistor is electrically connected to a first electrode of the third transistor;

an active pattern includes a channel region and a conductive region, and the conductive region of any active pattern is located at both sides of the channel region; wherein an active pattern of the second transistor and an active pattern of the fourth transistor are a first active layer, and an active pattern of the first transistor, an active pattern of the third transistor and an active pattern of the fifth transistor are a second active layer.

In an exemplary implementation, the active pattern of the first transistor and the active pattern of the fifth transistor are located on two sides of the active pattern of the third transistor, respectively, and the active pattern of the second transistor includes a first conductive region and a second conductive region; the active pattern of the fourth transistor includes a third conductive region and a fourth conductive region; the first conductive region and the third conductive region extend along the second direction, and the second conductive region and the fourth conductive region extend along the first direction; and the third conductive region is connected with the first conductive region.
In an exemplary implementation, the second conductive region is located on a side of the first conductive region close to the second active layer, and the second conductive region and at least a portion of the active pattern of the first transistor are located on a side of an active layer centerline, wherein the active layer centerline is a centerline of the second active layer extending along the first direction; and

the fourth conductive region is located on a side of the third conductive region close to the second active layer, and the fourth conductive region and at least a portion of the active pattern of the fifth transistor are located on the other side of the active layer centerline.

In an exemplary implementation, the display substrate further includes: a first signal line arranged on the base substrate, wherein at least a portion of the first signal line extends along the first direction, and a gate electrode of at least one transistor is arranged in a different layer from the first signal line; and

a resistivity of a film layer where the first signal line is located is smaller than a resistivity of a film layer where a gate electrode of the at least one transistor is located.

In an exemplary implementation, the gate electrode of the first transistor to the gate electrode of the fifth transistor are arranged at intervals;

a length of the gate electrode of the third transistor along the second direction is larger than a length of a gate electrode of any one of the first transistor, the second transistor, the fourth transistor and the fifth transistor along the second direction.

In an exemplary implementation, the pixel circuit further includes a capacitor, which includes a first electrode plate and a second electrode plate; the first electrode plate of the capacitor is located on a side of the second electrode plate of the capacitor close to the base substrate; and

an orthographic projection of the first electrode plate of the capacitor on the base substrate is at least partially overlapped with orthographic projections of the first conductive region, the active pattern of the third transistor, and the third conductive region on the base substrate.

In an exemplary implementation, the first signal line includes a third scan signal line, an initial signal line, a first power supply line, and a light emitting signal line; the first transistor is connected to the third scan signal line and the initial signal line, respectively, and the fifth transistor is connected to the first power supply line and the light emitting signal line, respectively; and

an orthographic projection of the second electrode plate of the capacitor on the base substrate is at least partially overlapped with orthographic projections of the third scan signal line, the initial signal line, the first power supply line, the light emitting signal line, the first electrode plate of the capacitor, the first conductive region and the third conductive region on the base substrate.

In an exemplary implementation, along the second direction, a distance between an orthographic projection of the gate electrode of the second transistor on the base substrate and an orthographic projection of the second electrode plate of the capacitor on the base substrate is less than a distance between the orthographic projection of the gate electrode of the second transistor on the base substrate and an orthographic projection of the gate electrode of the first transistor on the base substrate; and

a distance between an orthographic projection of the gate electrode of the fourth transistor on the base substrate and the orthographic projection of the second electrode plate of the capacitor on the base substrate is less than a distance between the orthographic projection of the gate electrode of the fourth transistor on the base substrate and an orthographic projection of the gate electrode of the fifth transistor on the base substrate.

In an exemplary implementation, the second electrode plate of the capacitor is provided with a groove that exposes at least a portion of regions of the first electrode plate of the capacitor, the first conductive region, and the third conductive region.

In an exemplary implementation, within a same sub-pixel, an opening direction of the groove is located on a side away from the second active layer.

In an exemplary implementation, the second electrode plate of the capacitor includes a capacitor main body portion, a first capacitor connection portion and a second capacitor connection portion, wherein the first capacitor connection portion and the second capacitor connection portion are located on two sides of the capacitor main body portion, respectively, and the groove is provided on a side of the capacitor main body portion;

the capacitor main body portion extends along the first direction, the first capacitor connection portion at least partially extends along the second direction, and the second capacitor connection portion extends along the second direction; and

an average length of the capacitor main body portions along the first direction is larger than an average length of the first capacitor connection portions along the first direction, and the average length of the first capacitor connection portions along the first direction is larger than an average length of the second capacitor connection portions along the first direction.

In an exemplary implementation, an orthographic projection of the capacitor main body portion on the base substrate is at least partially overlapped with orthographic projections of the first electrode plate of the capacitor, the first conductive region, and the third conductive region on the base substrate; and

orthographic projections of the first capacitor connection portion and the second capacitor connection portion on the base substrate are at least partially overlapped with orthographic projections of the first conductive region and the third conductive region on the base substrate, and are not overlapped with an orthographic projection of the first electrode plate of the capacitor on the base substrate.

In an exemplary implementation, the first electrode plate of the capacitor includes a first region and a second region; the first region is a region exposed by a groove of the second electrode plate of the capacitor, and the second region is all regions except the first region; and

an orthographic projection of the second electrode plate of the capacitor on the base substrate covers an orthographic projection of the second region of the first electrode plate of the capacitor on the base substrate.

In an exemplary implementation, the first signal line further includes a reference signal line, a first scan signal line, and a second scan signal line, the second transistor is connected to the second scan signal line and the reference signal line, respectively, and the fourth transistor is connected to the first scan signal line; and

the reference signal line, the second scan signal line, the initial signal line, the third scan signal line, the light emitting signal line, the first power supply line and the first scan signal line are arranged sequentially along the first direction.

In an exemplary implementation, the display substrate further includes: a second signal line arranged on the base substrate, which extends along the second direction and includes a data signal line; and

an orthographic projection of the data signal line on the base substrate is at least partially overlapped with orthographic projections of the first conductive region, the third conductive region, the fourth conductive region and the second electrode plate of the capacitor on the base substrate.

In an exemplary implementation, the data signal line includes a data signal main body line and a plurality of data signal connection lines, the data signal main body line extends along the second direction and the data signal connection lines extend along the first direction; and

an orthographic projection of the data signal main body line on the base substrate is at least partially overlapped with orthographic projection of the first conductive region, the third conductive region and the second electrode plate of the capacitor on the base substrate, and an orthographic projection of the data signal connection line on the base substrate is at least partially overlapped with an orthographic projection of the fourth conductive region on the base substrate.

In an exemplary implementation, the display substrate further includes: a driving structure layer arranged on the base substrate; the driving structure layer includes a semiconductor layer, a first conductive layer, a second conductive layer, a third conductive layer and a fourth conductive layer which are sequentially stacked on the base substrate;

the semiconductor layer at least includes: an active pattern of a first transistor, an active pattern of a second transistor, an active pattern of a third transistor, an active pattern of a fourth transistor, and an active pattern of a fifth transistor, which are located in at least one sub-pixel;

the first conductive layer at least includes: a gate electrode of the first transistor, a gate electrode of the second transistor, a gate electrode of the third transistor, a gate electrode of the fourth transistor, a gate electrode of a fifth transistor and a first electrode plate of the capacitor, which are located in least one sub-pixel;

the second conductive layer at least includes: a second electrode plate of the capacitance, which is located in at least one sub-pixel;

the third conductive layer at least includes: a first scan signal line, a second scan signal line, a third scan signal line, a light emitting signal line, a reference signal line, a first power supply line, an initial signal line, and a second electrode of the first transistor, a second electrode of the second transistor, a second electrode of the third transistor, a first electrode and a second electrode of the fourth transistor, which are located in least one sub-pixel; and

the fourth conductive layer at least includes: a data signal line.

In an exemplary implementation, the driving structure layer further includes a first planarization layer and a fifth insulation layer that are between the third conductive layer and the fourth conductive layer;

the fifth insulation layer is located on a side of the first planarization layer away from the base substrate; and

a thickness of the first planarization layer is greater than a thickness of the fifth insulation layer.

In an exemplary implementation, the thickness of the first planarization layer is 1.4 microns to 2.3 microns, and the thickness of the fifth insulation layer is 50 nanometers to 2500 nanometers.

In an exemplary implementation, a thickness of the third conductive layer is greater than a thickness of the first conductive layer or a thickness of the second conductive layer; and

a resistivity of the fourth conductive layer is smaller than a resistivity of the first conductive layer.

In a second aspect, the present disclosure further provides a display apparatus, including the display substrate described above.

Other aspects of the present disclosure may be comprehended after the drawings and the detailed descriptions are read and understood.

Brief Description of Drawings

Accompany drawings are used to provide understanding of technical solution of the present disclosure, and form a part of the specification. The accompany drawings and embodiments of the present disclosure are adopted to explain the technical solution of the present disclosure, and do not form limitations on the technical solution of the present disclosure.

FIG. 1 is a schematic diagram of a structure of a display apparatus.

FIG. 2 is a schematic diagram of a planar structure of a display substrate.

FIG. 3 is a schematic diagram of a planar structure of another display substrate.

FIG. 4A is a schematic diagram of an equivalent circuit of a pixel circuit.

FIG. 4B is a working timing diagram of the pixel circuit provided in FIG. 4A.

FIG. 5 is a schematic diagram of a structure of a display substrate according to an embodiment of the present disclosure.

FIG. 6 is a cross-sectional view of a display substrate according to an embodiment of the present disclosure.

FIG. 7 is a first schematic diagram of a partial film layer of the display substrate provided in FIG. 5.

FIG. 8 is a second schematic diagram of a partial film layer of the display substrate provided in FIG. 5.

FIG. 9 is a third schematic diagram of a partial film layer of the display substrate provided in FIG. 5.

FIG. 10 is a fourth first schematic diagram of a partial film layer of the display substrate provided in FIG. 5.

FIG. 11 is a schematic diagram after a pattern of a semiconductor layer is formed.

FIG. 12 is a schematic diagram of a pattern of a first conductive layer.

FIG. 13 is a schematic diagram after a pattern of a first conductive layer is formed.

FIG. 14 is a schematic diagram of a pattern of a second conductive layer.

FIG. 15 is a schematic diagram after a pattern of a second conductive layer is formed.

FIG. 16 is a schematic diagram after a pattern of a fourth insulation layer is formed.

FIG. 17 is a schematic diagram of a pattern of a third conductive layer.

FIG. 18 is a schematic diagram after a pattern of a third conductive layer is formed.

FIG. 19 is a schematic diagram after a pattern of a fifth insulation layer is formed.

FIG. 20 is a schematic diagram of a pattern of a fourth conductive layer.

FIG. 21 is a schematic diagram after a pattern of a fourth conductive layer is formed.

Detailed Description

To make the objectives, technical solutions, and advantages of the present disclosure clearer, the embodiments of the present disclosure will be described in detail below with reference to the accompany drawings. It is to be noted that implementation modes may be implemented in multiple different forms. Those of ordinary skills in the art can easily understand such a fact that implementation modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings of the embodiments of the present disclosure only involve structures involved in the embodiments of the present disclosure, and for other structures, reference may be made to conventional designs.

In the accompanying drawings, a size of each composition element, a thickness of a layer, or a region may be exaggerated sometimes for clarity. Therefore, an implementation of the present disclosure is not always limited to the size, and the shape and size of each component in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, "electrical connection" includes connection of composition elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

In the specification, "arranged in a same layer" refers to a structure formed by patterning two (or more than two) structures through a same patterning process, and their materials may be the same or different. For example, materials of precursors for forming multiple structures arranged in a same layer are the same, and final materials may be the same or different.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In the present disclosure, "about" refers to that a boundary is not defined so strictly and numerical values within a range of process and measurement errors are allowed.

Low Temperature Poly-Silicon (LTPS for short) technology or Low Temperature Poly-Silicon and Oxide (LTPO) technology is used in the display substrate, which has the advantages of high resolution, high reaction speed, high brightness and high aperture ratio, and is popular in the market. Display products using LTPS technology or LTPO technology are difficult to achieve high PPI display and easy to produce the leakage current because of complex connectivity of pixel circuits, large number of gate control lines and large electrodes occupied by pixel circuit.

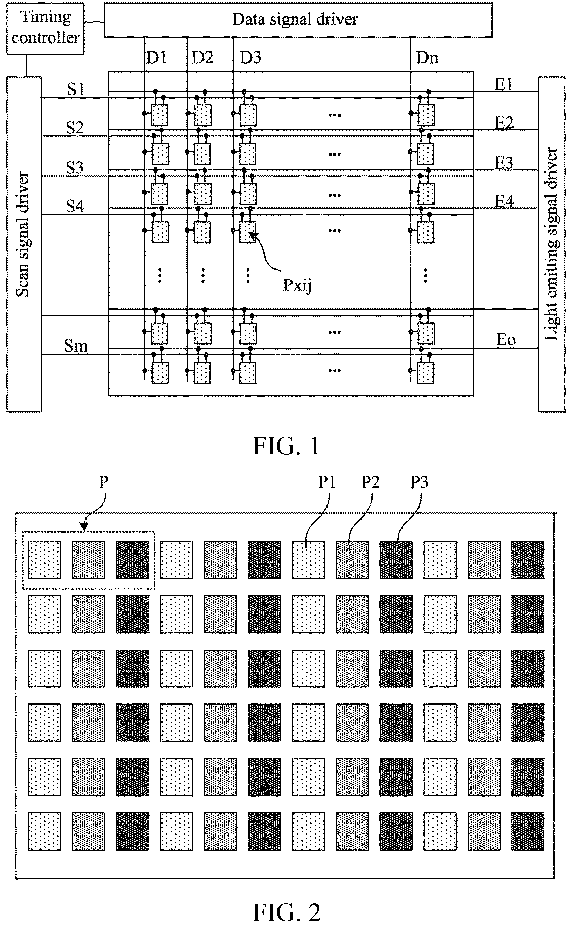

FIG. 1 is a schematic diagram of a structure of a display apparatus. As shown in FIG. 1, the display apparatus may include a timing controller, a data driver, a scan driver, a light emitting driver, and a pixel array. The timing controller is connected with the data driver, the scan driver, and the light emitting driver, respectively, the data driver is connected with a plurality of data signal lines (D1 to Dn) respectively, the scan driver is connected with a plurality of scan signal lines (S1 to Sm) respectively, and the light emitting driver is connected with a plurality of light emitting signal lines (E1 to Eo) respectively. The pixel array may include a plurality of sub-pixels Pxij, wherein i and j may be natural numbers. At least one sub-pixel Pxij may include a circuit unit and a light emitting device connected with the circuit unit, wherein the circuit unit may include a pixel circuit, and the pixel circuit may be connected with a scan signal line, a light emitting signal line, and a data signal line, respectively. In an exemplary implementation, the timing controller may provide the data driver with a gray scale value and a control signal which are suitable for the specification of the data driver, provide the scan driver with a clock signal and a scan start signal and the like which are suitable for the specification of the scan driver, and provide the light emitting driver with a clock signal and an emission stop signal and the like which are suitable for the specification of the light emitting driver. The data driver may generate data voltages to be provided to the data signal lines D1, D2, D3, ..., and Dn using the gray scale value and the control signal that are received from the timing controller. For example, the data driver may sample the gray scale value using the clock signal and apply a data voltage corresponding to the gray scale value to the data signal lines D1 to Dn by taking a pixel row as a unit, wherein n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number.

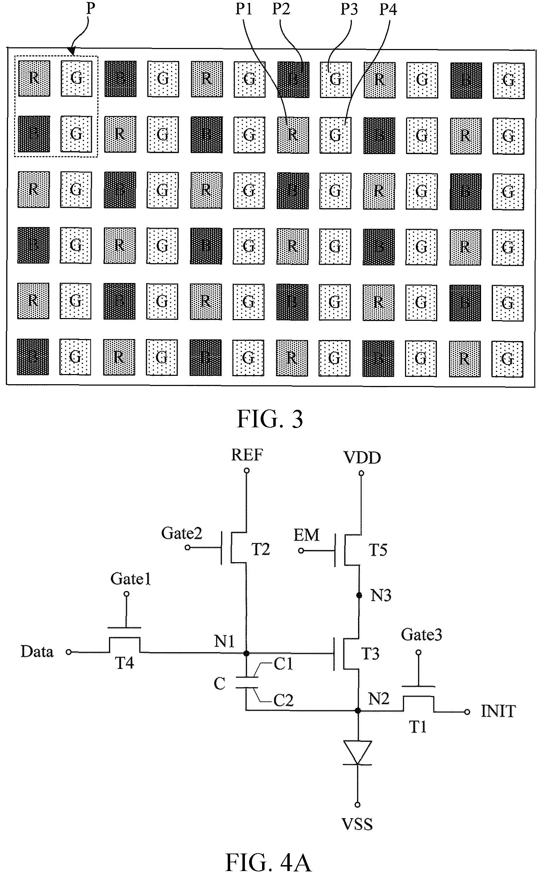

FIG. 2 is a schematic diagram of a planar structure of a display substrate. FIG. 3 is a schematic diagram of a planar structure of another display substrate. As shown in FIGS. 2 and 3, the display substrate may include a plurality of pixel units P arranged in a matrix, the plurality of pixel units P include a first sub-pixel P1 emitting light in a first color, a second sub-pixel P2 emitting light in a second color, and at least one third sub-pixel P3 emitting light in a third color, and each of the first sub-pixel P1, the second sub-pixel P2, and the third sub-pixel P3 includes a pixel circuit and a light emitting device. The pixel circuits in the first sub-pixel P1, the second sub-pixel P2, and the third sub-pixel P3 each are connected with a scan signal line, a data signal line, and a light emitting signal line respectively. The pixel circuit is configured to receive a data voltage transmitted by the data signal line under control of the scan signal line and the light emitting signal line, and output a corresponding current to the light emitting device. The light emitting devices in the first sub-pixel P1, the second sub-pixel P2, and the third sub-pixel P3 are respectively connected with respective pixel circuits of sub-pixels where light emitting devices are located, and the light emitting device is configured to emit light with a corresponding brightness in response to a current output by the pixel circuit of the sub-pixel where the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation, a sub-pixel may be in a shape of a rectangle, a rhombus, a pentagon, or a hexagon. Three sub-pixels may be arranged side by side horizontally, side by side vertically, or in a manner like a Chinese character "品", the present disclosure is not limited thereto.

In an exemplary implementation, as shown in FIG. 2, a pixel unit may include three sub-pixels that may be arranged in a manner of standing side by side horizontally, in a manner of standing side by side vertically, or in a manner like

a Chinese character "囧囧", which is not limited in the present disclosure. FIG. 2 is illustrated by taking standing side by side horizontally as an example.

In an exemplary implementation, as shown in FIG. 3, a pixel unit may include four sub-pixels which may be one first sub-pixel, one second sub-pixel, and two third sub-pixels. The four sub-pixels may be arranged in a manner of standing side by side horizontally, in a manner of standing side by side vertically, or in a manner of a square, which is not limited in the present disclosure. FIG. 3 illustrates four sub-pixels arranged in a manner of a square as an example.

In an exemplary implementation, the light emitting device may be an Organic Light Emitting Diode (OLED), including a first electrode (anode), an organic light emitting layer, and a second electrode (cathode), which are stacked.

In an exemplary implementation, the organic emitting layer may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL) that are stacked. In an exemplary implementation, hole injection layers of all sub-pixels may be connected together to be a common layer, electron injection layers of all the sub-pixels may be connected together to be a common layer, hole transport layers of all the sub-pixels may be connected together to be a common layer, electron transport layers of all the sub-pixels may be connected together to be a common layer, hole block layers of all the sub-pixels may be connected together to be a common layer, emitting layers of adjacent sub-pixels may be overlapped slightly or may be isolated, and electron block layers of adjacent sub-pixels may be overlapped slightly or may be isolated.

FIG. 4A is a schematic diagram of an equivalent circuit of a pixel circuit. In an exemplary implementation, the pixel circuit may have a structure of 3T1C, 4T1C, 5T1C, 5T2C, 6T1C, 7T1C, or 8T1C. As shown in FIG. 4A, the pixel circuit may include five transistors (a first transistor T1 to a fifth transistor T5), and one capacitor C. Herein, the capacitor C may include a first electrode plate C1 and a second electrode plate C2.

In an exemplary implementation, as shown in FIG. 4A, a gate electrode of the first transistor T1 is electrically connected to a third scan signal line Gate3, a first electrode of the first transistor T1 is electrically connected to an initial signal line INIT, and a second electrode of the first transistor T1 is electrically connected to a second node N2; a gate electrode of the second transistor T2 is electrically connected to a second scan signal line Gate2, a first electrode of the second transistor T2 is electrically connected to a reference signal line REF, and a second electrode of the second transistor T2 is electrically connected to a first node N1; a gate electrode of the third transistor T3 is electrically connected to the first node N1, a first electrode of the third transistor T3 is electrically connected to the second node N2, and a second electrode of the third transistor T3 is electrically connected to a third node N3; a gate electrode of the fourth transistor T4 is electrically connected to a first scan signal line Gate1, a first electrode of the fourth transistor T4 is electrically connected to a data signal line Data, and a second electrode of the fourth transistor T4 is electrically connected to the first node N1; a gate electrode of the fifth transistor T5 is electrically connected to a light emitting signal line EM, a first electrode of the fifth transistor T5 is electrically connected to a first power supply line VDD, and a second electrode of the fifth transistor T5 is electrically connected to the third node N3; and a first electrode plate C1 of the capacitor C is electrically connected to the first node N1, and a second electrode plate C2 of the capacitor C is electrically connected to the second node N2.

In an exemplary implementation, the light emitting device L may be electrically connected with the second node N2 and a second power supply line VSS, respectively. Herein, a first electrode of the light emitting device L is electrically connected to the second node N2, and a second electrode of the light emitting device L is electrically connected to the second power supply line VSS.

In an exemplary implementation, the light emitting device, which includes a current-driven device, may use a current-type light emitting diode, such as a micro light emitting diode (Micro LED), or a mini light emitting Diode (Mini LED), or an Organic light emitting diode (OLED), or a quantum light emitting diode (QLED). A typical size (e.g., length) of a Micro LED may be less than 100 $\mu$m, e.g., 10 $\mu$m to 50 $\mu$m. A typical size (e.g., length) of a Mini LED may be about 100 $\mu$m to 300 $\mu$m, e.g., 120 $\mu$m to 260 $\mu$m.

In an exemplary implementation, the first transistor T1 may be referred to as an anode reset transistor, and when a signal of the third scan signal line Gate3 is an effective level signal, the initial signal of the initial signal line INIT is written into the first electrode of the light emitting device L, so as to initialize the first electrode of the light emitting device L.

In an exemplary implementation, the second transistor T2 may be referred to as a node reset transistor, and when the signal of the second scan signal line Gate2 is an active level signal, a signal of the reference signal line REF is written to the first node N1, so as to initialize a signal of the first node N1.

In an exemplary implementation, the third transistor T3 may be referred to as a drive transistor, and the third transistor T3 determines a magnitude of a driving current flowing between the first power supply line VDD and the second power supply line VSS according to a potential difference between the gate electrode and the second electrode of the third transistor T3.

In an exemplary implementation, the fourth transistor T4 may be referred to as a writing transistor, which writes an initial signal of the data signal line Data to the second node N2 when a signal of the first scan signal line Gate1 is an active level signal.

In an exemplary implementation, the fifth transistor T5 may be referred to as a light emitting transistor. When the signal of the light emitting signal line EM is an active level signal, the fifth transistor T5 causes the light emitting device to emit light by forming a driving current path between the first power supply line VDD and a second power supply line VSS.

Transistors may be divided into N-type transistors and P-type transistors according to their characteristics. When a transistor is a P-type transistor, its turn-on voltage is a low-level voltage (e.g., 0V, -5V, -10V, or another suitable voltage), and its turn-off voltage is a high-level voltage (e.g., 5V, 10V, or another suitable voltage). When a transistor is an N-type transistor, its turn-on voltage is a high-level voltage (e.g., 5V, 10V, or another suitable voltage), and its turn-off voltage is a low-level voltage (e.g., 0 V, -5 V, -10 V, or another suitable voltage).

In an exemplary implementation, for the first transistor T1 to the fifth transistor T5, low temperature poly silicon thin film transistors may be adopted, or oxide thin film transistors may be adopted, or both of a low temperature poly silicon thin film transistor and an oxide thin film transistor may be adopted. An active layer of a low temperature poly silicon thin film transistor is made of Low Temperature Poly silicon (LTPS for short), and an active layer of an oxide thin film transistor is made of an oxide semiconductor (Oxide). A Low-temperature Poly Silicon thin film transistor has advantages such as a high mobility rate and fast charging, and an oxide thin film transistor has advantages such as a low leakage current. The Low Temperature Poly Silicon thin film transistor and the oxide thin film transistor are integrated on one display substrate to form a LTPO display substrate, and advantages of both the Low Temperature Poly Silicon thin film transistor and the oxide thin film transistor may be utilized, which can achieve low frequency drive, reduce power consumption, and improve display quality.

In an exemplary implementation, transistors of the first transistor T1 to the fifth transistor T5 may be N-type transistors.

In an exemplary implementation, the first power supply line VDD continuously provides a high-level signal, which is a constant voltage signal, the second power supply line VSS continuously provides a low-level signal, and the initial signal line INIT provides a constant voltage signal.

In an exemplary implementation, a voltage value of the signal of the initial signal line INIT may be smaller than a voltage value of a signal of the second power supply line VSS, which can avoid false light emission of the light emitting device.

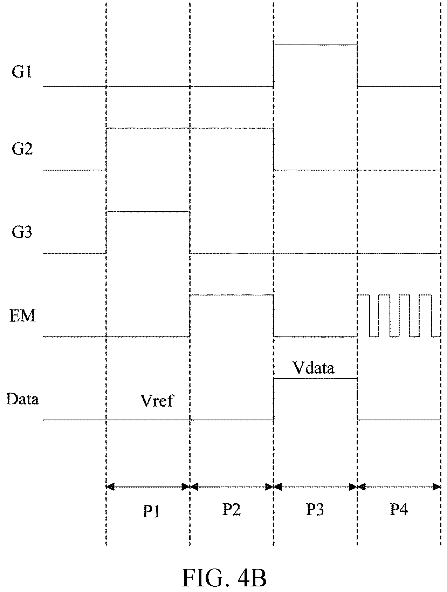

FIG. 4B is a working timing diagram of the pixel circuit provided in FIG. 4A. An exemplary embodiment of the present disclosure is described below with reference to an operation process of the pixel circuit illustrated in FIG. 4A during a display stage. FIG. 4B is illustrated by taking that the first transistor T1 to the fifth transistor T5 are N-type transistors as an example, and the pixel circuit in FIG. 4B includes the first transistor T1 to the fifth transistor T5, a capacitor C, and eight signal lines (a data signal line Data, a first scan signal line Gate1, a second scan signal line Gate2, a third scan signal line Gate3, an initial signal line INIT, a reference signal line REF, a light emitting signal line EM, and a first power supply line VDD).

In conjunction with FIGS. 4A and 4B, the working process of the pixel circuit may include following stages.

In a first stage P1, referred to as an initialization stage, the signals of the second scan signal line Gate2 and the third scan signal line Gate3 are high-level signals, and the signals of the first scan signal line Gate1 and the light emitting signal line EM are low-level signals. The signal of the second scan signal line Gate2 is a high-level signal, the second transistor T2 is turned on, and the signal of the reference signal line REF is written into the first node N1 through the turned-on second transistor T2, so as to initialize the signal of the first node N1. At this time, a voltage value of the signal of the first node N1 is $V_1=V_{ref}$, and $V_{ref}$ is a voltage value of the signal of the reference signal line REF. The signal of the third scan signal line Gate3 is a high-level signal, the first transistor T1 is turned on, and the signal of the initial signal line INIT is written into the second node N2, so as to initialize (reset) the first electrode of the light emitting device L, empty the pre-stored voltage inside the light emitting device L to complete the initialization. At this time, a voltage value of the signal of the second node N2 is $V_2=V_{init}$, and $V_{init}$ is a voltage value of the signal of the initial signal line INIT. In this stage, since the voltage value of the signal of the initial signal line INIT may be smaller than a voltage value of the signal of the second power supply line VSS, the light emitting device L does not emit light.

In a second stage P2, referred to as a threshold compensation stage, the signals of the second scan signal line Gate2 and the light emitting signal line EM are high-level signals, and the signals of the first scan signal line Gate1 and the third scan signal line Gate3 are low-level signals. The signal of the second scan signal line Gate2 is a high-level signal, the second transistor T2 is turned on, and the signal of the reference signal line REF is continuously written to the first node N1 through the turned-on second transistor T2. At this time, a voltage value of the signal of the first node N1 is $V_1=V_{ref}$. The signal of the light emitting signal line EM is a high-level signal, the fifth transistor T5 is turned on, the signal of the first power supply line VDD is written into the second node N2 through the turned-on fifth transistor T5, the third node N3 and the turned-on third transistor T3 until a voltage of the signal of the second node N2 is $V_2=V_{ref}-V_{th}$, $V_{th}$ is a threshold voltage of the third transistor T3. At this time, a voltage value of the signal of the third node N3 is $V_3=V_{vdd}$, $V_{vdd}$ is a voltage value of the signal of the first power supply line VDD, and the capacitor C stores a voltage difference $V_{th}$ of the signals of the first node N1 and the second node N2. The light emitting device L does not emit light in this stage.

In a third stage P3, referred to as a data writing stage, a signal of the first scan signal line Gate1 is a high-level signal, signals of the second scan signal line Gate2, the third scan signal line Gate3, and the light emitting signal line EM are low-level signals, and the data signal line Data outputs a data signal. The signal of the first scan signal line Gate1 is a high-level signal, the fourth transistor T4 is turned on, and the data signal of the data signal line Data is written into the first node N1 through the turned-on fourth transistor T4. At this time, a voltage value of the signal of the first node N1 is $V_1=V_{data}$, $V_{data}$ is a voltage value of the data signal, and the voltage value of the signal of the first node N1 jumps in this stage compared to the voltage value thereof in the previous stage. Therefore, under the action of the capacitor C, the signal of the second node N2 also jumps, and at this time, a voltage value of the signal of the second node N2 is $V_2=V_{ref}-V_{th}+\alpha(V_{data}-V_{ref})$. The light emitting device L does not emit light in this stage.

In a fourth stage P4, referred to as a light emitting stage, the signal of the light emitting signal line EM is a high-level signal, and the signals of the first scan signal line Gate1, the second scan signal line Gate2, and the third scan signal line Gate3 are low-level signals. The signal of the light emitting signal line EM is a high-level signal, the fifth transistor T5 is turned on, and the signal of the first power supply line VDD provides a driving current to the first electrode of the light emitting device L through the turned-on fifth transistor T5, the third node N3 and the turned-on third transistor T3, so as to drive the light emitting device L to emit light.

In a pixel circuit driving process, the driving current flowing through the third transistor T3 (the driving transistor) is determined by a voltage difference between the gate electrode (also the first node N1) and the second electrode (also the second node N2). Since a voltage value of the signal of the first node N1 is $V_1=V_{data}$, and a voltage value of the signal of the second node N2 is $V_2=V_{ref}-V_{th}+\alpha(V_{data}-V_{ref})$, a driving current of the third transistor T3 is:

$$I=K*(V_{gs}-Vth)^2=K*[(V_{data}-V_{ref}+V_{th}-\alpha(V_{data}-V_{ref}))-Vth]^2=K*[(1-\alpha)(V_{data}-V_{ref})]^2$$

Herein, I is the driving current flowing through the third transistor T3, that is, a driving current for driving the light emitting device L, K is a constant, and $V_{gs}$ is the voltage difference between the gate electrode and the second electrode of the third transistor T3.

In an exemplary implementation, the signal of the light emitting signal line EM may be a high-level signal or may be a low-level signal in a third stage. FIG. 4B is illustrated by taking that the signal of the light emitting signal line EM is a low-level signal in the third stage as an example. When the data signal line is used by a pixel circuit alone, the signal of the light emitting signal line EM may be a high-level signal or may be a low-level signal in the third stage. When the data signal line is common to adjacent pixel circuits, the signal of the light emitting signal line EM is a low-level signal in the third stage, otherwise the display of different pixel circuits is uneven.

In an exemplary implementation, the signal of the light emitting signal line EM may be a continuous high-level signal in the fourth stage P4 or may be a periodic pulse signal. When the signal of the light emitting signal line EM is a continuous high-level signal in the fourth stage P4, the light emitting device continuously emit light. When the signal of the light emitting signal line EM is a periodic pulse signal in the fourth stage P4, which may be used to modulate the pulse width of the light, that is, the light emitting device lights up and lights off unceasingly, rather than emitting light continuously.

In an exemplary implementation, the scan signal lines include a first scan signal line, a second scan signal line, and a third scan signal line.

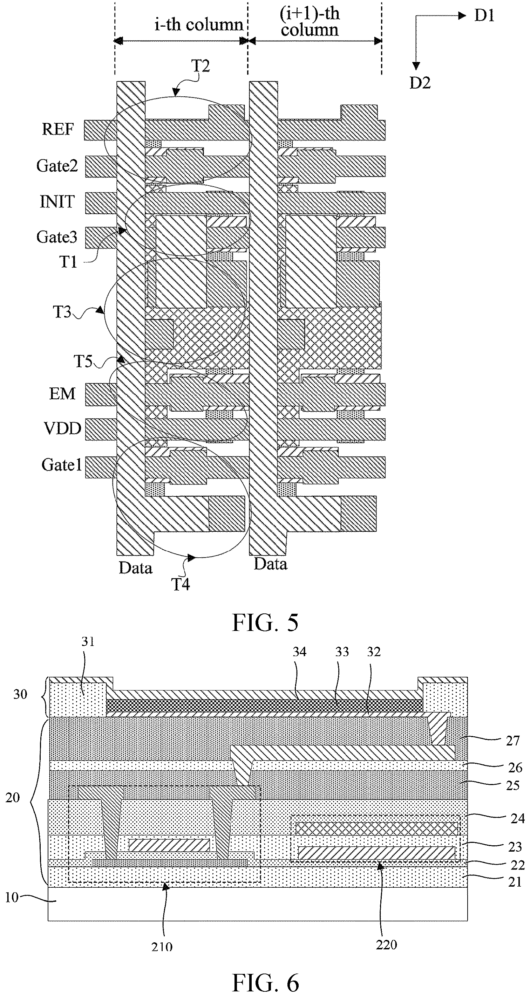

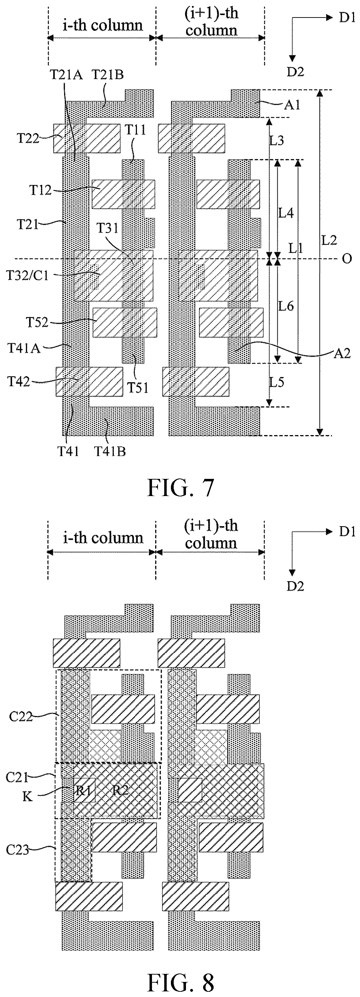

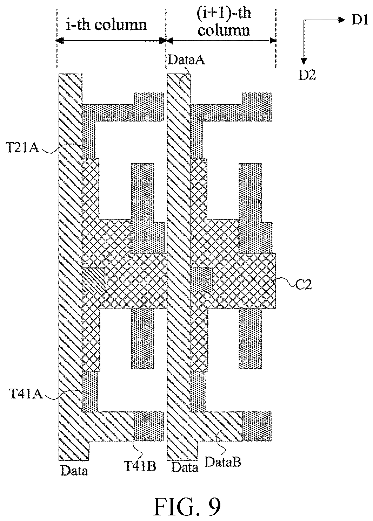

FIG. 5 is a schematic diagram of a structure of a display substrate according to an embodiment of the present disclosure, FIG. 6 is a cross-sectional view of a display substrate according to an embodiment of the present disclosure, FIG. 7 is a first schematic diagram of a partial film layer of the display substrate provided in FIG. 5, FIG. 8 is a second schematic diagram of a partial film layer of the display substrate provided in FIG. 5, and FIG. 9 is a third schematic diagram of a partial film layer of the display substrate provided in FIG. 5. As shown in FIGS. 5 to 9, the display substrate according to an embodiment of the present disclosure includes a base substrate 10 and a plurality of sub-pixels provided on the base substrate, and at least one sub-pixel includes a pixel circuit, which includes a third transistor T3 and a plurality of transistors connected to the third transistor T3. The transistor includes an active pattern, active patterns of at least two transistors connected to the gate electrode of the third transistor T3 are of an integral structure and are a first active layer A1, active patterns of at least two transistors connected to any one of the first electrode and the second electrode of the third transistor T3 and an active pattern T31 of the third transistor are of an integral structure and are a second active layer A2.

As shown in FIG. 7, the first active layer A1 and the second active layer A2 are arranged along the first direction D1 and extend at least partially along the second direction D2, and the first direction D1 intersects with the second direction D2. A length L1 of the first active layer A1 along the second direction D2 is larger than a length L2 of the second active layer A2 along the second direction D2. FIG. 5 is illustrated by taking two pixel circuits as an example.

In an exemplary implementation, the active layer of each sub-pixel includes a third transistor and active patterns of a plurality of transistors connected to the third transistor.

In an exemplary implementation, the display substrate may be an OLED display substrate or may be a Liquid Crystal Display (LCD) display substrate.

In an exemplary implementation, the base substrate may be a rigid base substrate or a flexible base substrate, wherein the rigid base substrate may be, but is not limited to, one or more of glass and conductive foil. The flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber.

In an exemplary implementation, the display substrate includes a display region and a non-display region surrounding at least one side of the display region. A plurality of sub-pixels may be located in the display region.

In an exemplary implementation, a shape of the display region may be a square or a rounded rectangle, or may also be other shapes, which is not limited in the present disclosure.

The display substrate according to an embodiment of the present disclosure includes a base substrate and a plurality of sub-pixels arranged on the base substrate, and at least one sub-pixel includes a pixel circuit, which includes a third transistor and a plurality of transistors connected with the third transistor; a transistor includes an active pattern, active patterns of at least two transistors connected to a gate electrode of the third transistor are of an integral structure and are the first active layer, and active patterns of at least two transistors connected to any one electrode of a first electrode and a second electrode of the third transistor and an active pattern of the third transistor are of an integral structure and are the second active layer. The first active layer and the second active layer are arranged along the first direction and extend at least partially along the second direction, and the first direction intersects with the second direction; and a length of the first active layer along the second direction is larger than a length of the second active layer along the second direction. Firstly, according to the present disclosure, the active layer of each sub-pixel includes only two portions by arranging the active patterns of a plurality of transistors into an integral structure, so that the active layer portions after conductorization may be directly connected between transistors, thus simplifying the process, improving a utilization rate of a layout space and facilitating the achievement of high PPI. Secondly, according to the present disclosure, the active patterns of at least two transistors connected with the gate electrode of the third transistor can be lengthened by arranging a length of the first active layer along the second direction larger than a length of the second active layer along the second direction, which can reduce the leakage current between at least two transistors connected with the gate electrode of the third transistor and improve the reliability of the display substrate.

In an exemplary implementation, as shown in FIG. 5, a plurality of transistors connected to the third transistor T3 include a first transistor T1, a second transistor T2, a fourth transistor T4, and a fifth transistor T5. Herein, a second electrode of the first transistor T1 is electrically connected to a second electrode of the third transistor T3, a second electrode of the second transistor T2 and a second electrode of the fourth transistor T4 are connected to a gate electrode of the third transistor T3, respectively, and a second electrode of the fifth transistor T5 is electrically connected to a first electrode of the third transistor T3.

In an exemplary implementation, the first transistor T1 to the fifth transistor T5 are N-type transistors.

In an exemplary implementation, the active pattern includes a channel region and a conductive region, and the conductive region of any of the active pattern is located on both sides of the channel region.

In an exemplary implementation, as shown in FIG. 7, the active pattern T21 of the second transistor and the active pattern T41 of the fourth transistor are the first active layer A1, and the active pattern T11 of the first transistor, the active T31 layer of the third transistor and the active pattern T51 of the fifth transistor are the second active layer A2.

In an exemplary implementation, as shown in FIG. 7, the active pattern T11 of the first transistor and the active pattern T51 of the fifth transistor are located on two sides of the active pattern T31 of the third transistor, respectively.

In an exemplary implementation, as shown in FIG. 7, the active pattern T21 of the second transistor includes: a first conductive region T21A and a second conductive region T21B, and the active pattern T41 of the fourth transistor includes: a third conductive region T41A and a fourth conductive region T41B.

In an exemplary implementation, as shown in FIG. 7, the first conductive region T21A and the third conductive region T41A extend along the second direction D2, the second conductive region T21B and the fourth conductive region T41B extend along the first direction D1, and the third conductive region T41A is connected to the first conductive region T21A.

In an exemplary implementation, as shown in FIG. 7, the second conductive region T21B is located on a side of the first conductive region T21A close to the second active layer A2, and the second conductive region T21B and at least a portion of the active pattern of the first transistor are located on a side of an active layer centerline O; and the fourth conductive region T41B is located on a side of the third conductive region T41A close to the second active layer A2, and the fourth conductive region T41B and at least a portion of the active pattern of the fifth transistor are located on the other side of the active layer centerline O, wherein the active layer centerline O is a centerline of the second active layer extending along the first direction D1.

In an exemplary implementation, as shown in FIG. 7, a distance L3 between the second conductive region T21B and the active layer centerline O is greater than a distance L4 between a boundary of the active pattern T11 of the first transistor away from the active layer centerline O and the active layer centerline O. In an exemplary implementation, as shown in FIG. 7, a distance L5 between the fourth conductive region T41B and the active layer centerline O is greater than a distance L6 between a boundary of the active pattern T51 of the fifth transistor away from the active layer centerline O and the active layer centerline O.

In an exemplary implementation, as shown in FIG. 7, along the second direction D2, a distance between the second conductive region T21B and the second active layer A2 is less than or equal to a distance between the fourth conductive layer T41B and the second active layer A2. Herein, along the second direction D2, the distance between the second conductive region T21B and the second active layer A2 is equal to a difference between a distance L3, which is between the second conductive region T21B and the active layer centerline O, and a distance L4 between the boundary of the active pattern T11 of the first transistor away from active layer centerline O and the active layer centerline O; and along the second direction D2, a distance between the fourth conductive layer T41B and the second active layer A2 is equal to a difference between a distance L5, which is between the fourth conductive region T41B and the active layer centerline O, and a distance L6 from the active layer centerline O.

In an exemplary implementation, the display substrate may further include a first signal line arranged on the base substrate, at least a portion of the first signal line extends along the first direction D1, the gate electrode of at least one transistor is arranged in different layers from the first signal line, and a resistivity of the film layer where the first signal line is located is less than a resistivity of the film layer where the gate electrode of at least one transistor is located.

According to the present disclose, the gate electrode of at least one transistor is arranged in different layers from the first signal line, and a resistivity of a film layer where the first signal line is located is smaller than a resistivity of a film layer on which the gate electrode of at least one transistor is located. Firstly the film layer on which the gate electrode of at least one transistor is located may use a metal material with good stability, such as molybdenum. Since molybdenum is resistant to high temperature and will not be oxidized, there will be no abnormal connection even if it is excessively etched during subsequent film layer etching. Secondly, the first signal line may be made of low-resistance metal materials which are easy to oxidize and cannot withstand high temperature, such as aluminum, copper and other metals or their alloys, and a resistivity of the film layer where the first signal line is located is small, which can reduce the impedance of the first signal line and meet the requirements of high PPI and large-size display products for wire resistance.

In an exemplary implementation, the gate electrode T12 of the first transistor to the gate electrode T52 of the fifth transistor are arranged at intervals.

In an exemplary implementation, a length of the gate electrode of the third transistor along the second direction may be greater than a length of a gate electrode of any of the first transistor, the second transistor, the fourth transistor, and the fifth transistor along the second direction.

In an exemplary implementation, as shown in FIGS. 7 and 8, the pixel circuit further includes a capacitor, which includes a first electrode plate C1 and a second electrode plate C2; and the first electrode plate C1 of the capacitor is located on a side of the second electrode plate C2 of the capacitor close to the base substrate. FIG. 7 shows only the first electrode plate C1 of the capacitor.

In an exemplary implementation, as shown in FIG. 7, the first electrode plate of the capacitor is arranged in the same layer as the active pattern of the transistor or may be arranged in the same layer as the gate electrode of the transistor. When the first electrode plate of the capacitor and the gate electrode of the transistor are arranged in the same layer, the first electrode plate C1 of the capacitor may be reused as the gate electrode T32 of the third transistor. According to the present disclosure, reusing the first electrode plate C1 of the capacitor as the gate electrode T32 of the third transistor, which can increase an area of the first electrode plate of the capacitor, so as to maximize the first electrode plate of the capacitor and facilitate the achievement of high PPI. FIG. 5 to FIG. 9 are illustrated by taking that the first electrode plate of the capacitor is arranged in the same layer as the gate electrode of the transistor as an example.

In an exemplary implementation, in conjunction with FIGS. 7 and 8, when the first electrode plate of the capacitor is arranged in the same layer as the gate electrode of the transistor, an orthographic projection of the first electrode plate C1 of the capacitor on the base substrate is at least partially overlapped with orthographic projections of the first conductive region, the active pattern of the third transistor and the third conductive region on the base substrate.

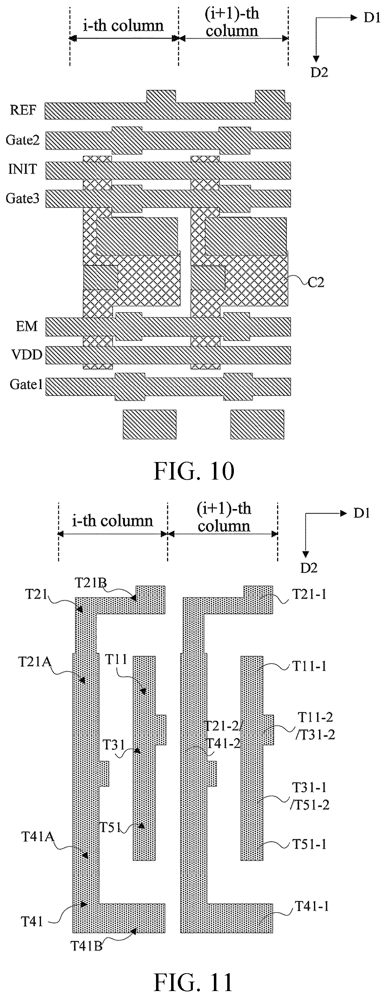

In an exemplary implementation, FIG. 10 is a fourth schematic diagram of a partial film layer of the display substrate provided in FIG. 5. As shown in FIG. 5 and FIG. 10, the first signal line may include a third scan signal line Gate3, an initial signal line INIT, a first power supply line VDD, and a light emitting signal line EM. The first transistor is connected to the third scan signal line and the initial signal line, respectively, and the fifth transistor is connected to the first power supply line and the light emitting signal line, respectively.

In an exemplary implementation, as shown in conjunction with FIGS. 5, 7, 8 and 10, an orthographic projection of the second electrode plate C2 of the capacitor on the base substrate is at least partially overlapped with orthographic projections of the third scan signal line Gate3, the initial signal line INIT, the first power supply line VDD, the light emitting signal line EM, the first electrode plate C1 of the capacitor, the first conductive region and the third conductive region on the base substrate. According to the present disclosure, the orthographic projection of the second electrode plate of the capacitor on the base substrate is arranged to be at least partially overlapped with the orthographic projections of the third scan signal line, the first power supply line and the first electrode plate of the capacitor, which maximize an area of the capacitor and improve the reliability of the display substrate.

In an exemplary implementation, as shown in FIG. 8, along the second direction D2, a distance between an orthographic projection of the gate electrode of the second transistor on the base substrate and an orthographic projection of the second electrode plate of the capacitor on the base substrate is less than a distance between the orthographic projection of the gate electrode of the second transistor on the base substrate and an orthographic projection of the gate electrode of the first transistor on the base substrate, and a distance between an orthographic projection of the gate electrode of the fourth transistor on the base substrate and the orthographic projection of the second electrode plate of the capacitor on the base substrate is less than a distance between the orthographic projection of the gate electrode of the fourth transistor on the base substrate and an orthographic projection of the gate electrode of the fifth transistor on the base substrate. According to the present disclosure, the distance between the orthographic projection of the gate electrode of the second transistor on the base substrate and the orthographic projection of the second electrode plate of the capacitor on the base substrate is smaller than the distance between the orthographic projection of the gate electrode of the second transistor on the base substrate and the orthographic projection of the gate electrode of the first transistor on the base substrate, and the distance between the orthographic projection of the gate electrode of the fourth transistor on the base substrate and the orthographic projection of the second electrode plate of the capacitor on the base substrate is smaller than the distance between the orthographic projection of the gate electrode of the fourth transistor on the base substrate and the orthographic projection of the gate electrode of the fifth transistor on the base substrate, which can increase the area of the second electrode plate of the capacitor without affecting the signal transmission, so as to maximize the first electrode plate and the second electrode plate of the capacitor and facilitate the achievement of the high PPI.

In an exemplary implementation, as shown in FIG. 8, the second electrode plate C2 of the capacitor is provided with a groove K, which exposes at least a portion of regions of the first electrode plate C1 of the capacitor, the first conductive region T21A, and the third conductive region T41A.

In an exemplary implementation, as shown in FIG. 8, within the same sub-pixel, an opening direction of the groove K is located on a side away from the second active layer.

In an exemplary implementation, as shown in FIG. 8, the second electrode plate C2 of the capacitor includes a capacitor main body portion C21, a first capacitor connection portion C22 and a second capacitor connection portion C23, wherein the first capacitor connection portion C22 and the second capacitor connection portion C23 are located on two sides of the capacitor main body portion C21, respectively, and are connected to the capacitor main body portion C21, respectively, and the groove K is provided on a side of the capacitor main body portion C21.

In the exemplary implementation, as shown in FIG. 8, the capacitor main body portion C21 extends along the first direction D1, the first capacitor connection portion C22 extends at least partially along the second direction D2, and the second capacitor connection portion C23 extends along the second direction D2.

In an exemplary implementation, as shown in FIG. 8, an average length of the capacitor main body portions C21 along the first direction D1 is larger than an average length of the first capacitor connection portions C22 along the first direction D1, and an average length of the first capacitor connection portions C22 along the first direction D1 is larger than an average length of the second capacitor connection portions C23 along the first direction D1.

In an exemplary implementation, as shown in FIG. 8, in an exemplary implementation, an orthographic projection of the capacitor main body portion C21 on the base substrate is at least partially overlapped with orthographic projections of the first electrode plate C1 of the capacitor, the first conductive region T21A and the third conductive region T41A on the base substrate.

In an exemplary implementation, as shown in FIG. 8, orthographic projections of the first capacitor connection portion C22 and the second capacitor connection portion C23 on the base substrate are at least partially overlapped with orthographic projections of the first conductive region T21A and the third conductive region T41A on the base substrate, and are not overlapped with an orthographic projection of the first electrode plate C1 of the capacitance on the base substrate.

In an exemplary implementation, as shown in FIG. 8, the first electrode plate C1 of the capacitor includes a first region R1 and a second region R2. The first region R1 is a region exposed by a groove of the second electrode plate of the capacitor, and the second region R2 is all regions except the first region R1. An orthographic projection of the second electrode plate C2 of the capacitor on the base substrate covers an orthographic projection of the second region R2 of the first electrode plate of the capacitor on the base substrate.

Since the first electrode plate of the capacitor is in a floating state for most of the time and is susceptible to interference, according to the present disclosure, the orthographic projection of the second electrode plate C2 of the capacitor on the base substrate is arranged to cover the orthographic projection of the second region R2 of the first electrode plate of the capacitor on the base substrate, so that the first electrode plate of the capacitor may be arranged under the second electrode plate C2 of the capacitor to the maximum extent, which can effectively shield the first electrode plate of the capacitor from noise interference and improve the reliability of the display substrate.

In an exemplary implementation, as shown in FIG. 5, the first signal line further includes a reference signal line REF, a first scan signal line Gate1 and a second scan signal line Gate2, the second transistor is connected to the second scan signal line and the reference signal line, respectively, and the fourth transistor is connected to the first scan signal line.

In the exemplary implementation, as shown in FIG. 5, the reference signal line REF, the second scan signal line Gate2, the initial signal line INIT, the third scan signal line Gate3, the light emitting signal line EM, the first power supply line VDD, and the first scan signal line Gate1 are arranged sequentially along the first direction D1.

In an exemplary implementation, as shown in FIG. 5, the display substrate may further include a second signal line provided on the base substrate, which extends along the second direction D2 and includes a data signal line Data.

In an exemplary implementation, as shown in FIGS. 5 and 9, an orthographic projection of the data signal line Data on the base substrate is at least partially overlapped with orthographic projections of the first conductive region T21A, the third conductive region T41A, the fourth conductive region T41B and the second electrode plate C2 of the capacitor on the base substrate. In an exemplary implementation, the orthographic projection of the data signal line Data on the base substrate is at least partially overlapped with the orthographic projections of the first conductive region, the third conductive region, the fourth conductive region and the second electrode plate of the capacitor on the base substrate, so that the space of the display substrate can be saved so as to achieve the high PPI.

In an exemplary implementation, the data signal line Data includes a data signal main body line DataA and a plurality of data signal connection lines DataB. Herein, the data signal main body line DataA extends along the second direction D2, and the data signal connection line DataB extends along the first direction D1.

In an exemplary implementation, an orthographic projection of the data signal main body line DataA on the base substrate is at least partially overlapped with orthographic projections of the first conductive region, the third conductive region and the second electrode plate of the capacitor on the base substrate, and an orthographic projection of the data signal connection line DataB on the base substrate is at least partially overlapped with an orthographic projection of the fourth conductive region on the base substrate.

In an exemplary implementation, as shown in FIG. 6, the display substrate may further include a driving structure layer 20 arranged on the base substrate 10; the driving structure layer 20 includes a semiconductor layer, a first conductive layer, a second conductive layer, a third conductive layer and a fourth conductive layer which are stacked sequentially on the base substrate 10.

The semiconductor layer at least includes: an active pattern of a first transistor, an active pattern of a second transistor, an active pattern of a third transistor, an active pattern of a fourth transistor, and an active pattern of a fifth transistor, which are located in at least one sub-pixel.

The first conductive layer at least includes: a gate electrode of the first transistor, a gate electrode of the second transistor, a gate electrode of the third transistor, a gate electrode of the fourth transistor, a gate electrode of a fifth transistor and a first electrode plate of the capacitor, which are located in least one sub-pixel.

The second conductive layer at least includes: a second electrode plate of the capacitor, which is located in at least one sub-pixel.

The third conductive layer at least includes: a first scan signal line, a second scan signal line, a third scan signal line, a light emitting signal line, a reference signal line, a first power supply line, an initial signal line, and a second electrode of the first transistor, a second electrode of the second transistor, a second electrode of the third transistor, a first electrode and a second electrode of the fourth transistor, which are located in least one sub-pixel.

The fourth conductive layer at least includes a data signal line.

In an exemplary implementation, the drive circuit layer 20 of each sub-pixel may include a plurality of transistors and a capacitor, which constitute a pixel circuit. In FIG. 6, only one transistor 210 and one capacitor 220 are taken as an example.

In an exemplary implementation, the display substrate may further include a light emitting structure layer 30 arranged on a side of the driving circuit layer20 away from the base substrate 10, and an encapsulation structure layer arranged on a side of the light emitting structure layer 30 away from the base substrate 10. In some possible implementations, the display substrate may include another film layer, such as a touch structure layer, which is not limited here in the present disclosure.

In an exemplary implementation, the light emitting structure layer 30 may include an anode 32, a pixel definition layer 31, an organic light emitting layer 33 and a cathode 34. The anode 32 is connected to a drain electrode of the drive transistor 210 through a via hole, the organic light emitting layer 33 is connected to the anode 32, the cathode 34 is connected to the organic light emitting layer 33, and the organic light emitting layer 33 emits light of a corresponding color under the driving of the anode 32 and the cathode 34.

In an exemplary implementation, the encapsulation structure layer may include a first encapsulation layer, a second encapsulation layer 402, and a third encapsulation layer that are stacked. The first encapsulation layer and the third encapsulation layer may be made of an inorganic material, and the second encapsulation layer may be made of an organic material. The second encapsulation layer is provided between the first encapsulation layer and the third encapsulation layer, which can ensure that external water vapor cannot enter the light emitting structure layer.

In an exemplary implementation, the touch structure layer of each sub-pixel may include a first touch insulation layer arranged on the encapsulation structure layer, a first touch metal layer arranged on the first touch insulation layer, a second touch insulation layer covering the first touch metal layer, a second touch metal layer arranged on the second touch insulation layer, and a touch protection layer covering the second touch metal layer 44, wherein the first touch metal layer may include a plurality of bridge electrodes, the second touch metal layer may include a plurality of first touch electrodes and second touch electrodes, and the first touch electrodes or the second touch electrodes may be connected to the bridge electrodes through via holes.

In an exemplary implementation, a metal material having a good stability such as molybdenum may be used as the fabrication material of the first conductive layer and the second conductive layer. Since molybdenum is resistant to high temperature and will not be oxidized, there is no abnormal connection even if the first conductive layer and the second conductive layer are excessively etched during subsequent film layer etching.

In an exemplary implementation, a resistivity of the third conductive layer may be less than a resistivity of the first conductive layer.

In an exemplary implementation, a resistivity of the fourth conductive layer is smaller than a resistivity of the first conductive layer, which may be formed of a fabrication material such as aluminum, copper, or an alloy thereof. A resistivity of the fourth conductive layer is relatively small, which can reduce an impedance of the second signal line and meet the requirements of the display products with the high PPI and large sizes for the wire resistance.

In an exemplary implementation, a thickness of the third conductive layer may be greater than a thickness of the first conductive layer or a thickness of the second conductive layer.

In an exemplary implementation, a thickness of the third conductive layer may be greater than 500 nanometers, and exemplarily, a thickness of the third conductive layer may be 500 nanometers or may be 650 nanometers.

In an exemplary implementation, the thicknesses of the third conductive layer and the thicknesses of the fourth conductive layer may be the same or may be different, which is not limited in the present disclosure.

In an exemplary implementation, as shown in FIG. 6, the driving structure layer may further include a first insulation layer 21 arranged between the base substrate 10 and the semiconductor layer, a second insulation layer 22 arranged between the semiconductor layer and the first conductive layer, a third insulation layer 23 arranged between the first conductive layer and the second conductive layer, a fourth insulation layer 24 arranged between the second conductive layer and the third conductive layer, a first planarization layer 25 and a fifth insulation layer 26 arranged between the third conductive layer and the fourth conductive layer, and a second planarization layer 27 arranged on a side of the fourth conductive layer away from the base substrate.

In an exemplary implementation, the fifth insulation layer 26 is located on a side of the first planarization layer 25 away from the base substrate 10, and the fifth insulation layer is located on a side of the first planarization layer away from the base substrate, which can not only prevent damage to the first planarization layer during subsequent formation of the fourth conductive layer, but also not contaminate the deposition and etching devices of the fourth conductive layer.

In an exemplary implementation, a thickness of the first planarization layer 25 is greater than a thickness of the fifth insulation layer 26. The thickness of the first planarization layer is arranged so that the thickness of the first planarization layer is larger, which can not only reduce a short circuit risk between the third conductive layer and the fourth conductive layer, but also reduce a capacitance between signals of the third conductive layer and the fourth conductive layer, that is, a resistance and capacitance load can be reduced, which is more beneficial to the driving of a Panel with the high PPI and the large-size.

In an exemplary implementation, a thickness of the first planarization layer may be 1.4 microns to 2.3 microns.

In an exemplary implementation, a thickness of the fifth insulation layer may be from 50 nanometers to 2500 nanometers.

In an exemplary implementation, the second planarization layer may flatten a segment difference of the fourth conductive layer, which can improve flatness of the driving structure layer and facilitate the subsequent fabrication of the light emitting structure layer.

In an exemplary implementation, the driving structure layer may further include a sixth insulation layer between the fourth conductive layer and the second planarization layer.

In an exemplary implementation, as shown in FIG. 5, the second transistor T2 and the fourth transistor T4 are provided at an edge of the entire pixel circuit, so that a jumper of the signal line connected to the fourth transistor T4 may be minimized, which can minimize the capacitance and resistance load, and improve the driving capability of the pixel circuit.

In an exemplary implementation, as shown in FIG. 5, pixel structures of the pixel circuits of adjacent sub-pixels are the same. Adjacent sub-pixels include adjacent sub-pixels located in the same row and adjacent sub-pixels located in the same column.

In an exemplary implementation, the light emitting device may be a top emitting structure or may be a bottom emitting structure, which is not limited in the present disclosure. Herein, the top emitting structure means that the first electrode (the anode) of the light emitting device is a reflection electrode, and the second electrode (the cathode) of the light emitting device is a transmitting electrode. The bottom emitting structure means that the first electrode (the anode) of the light emitting device is a transmitting electrode, and the second electrode (the cathode) of the light emitting device is a reflection electrode.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition. The coating may be any one or more of spray coating, spin coating, and inkjet printing. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are arranged in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A coincides with the boundary of the orthographic projection of B.

FIG. 11 to FIG. 21 are schematic diagrams of a preparation process of a display substrate according to an exemplary implementation. FIGS. 11 to 21 are illustrated by taking sub-pixels with one row and two columns as an example. As shown in FIGS. 11 to 21, a manufacturing process for a display substrate according to an exemplary embodiment may include following acts.

(1) Forming a pattern of a semiconductor layer. In an exemplary implementation, forming the pattern of the semiconductor layer may include: depositing sequentially a first insulation thin film and a semiconductor thin film on a base substrate, and patterning the semiconductor thin film through a patterning process to form a first insulation layer covering the base substrate and the pattern of the semiconductor layer located on the first insulation layer. As shown in FIG. 11, FIG. 11 is a schematic diagram after a pattern of a semiconductor layer is formed.

In an exemplary implementation, as shown in FIG. 11, the pattern of the semiconductor layer may at least include an active pattern T11 of a first transistor, an active pattern T21 of a second transistor, an active pattern T31 of a third transistor, an active pattern T41 of a fourth transistor, and an active pattern T51 of a fifth transistor, which are located in at least one sub-pixel.

In an exemplary implementation, as shown in FIG. 11, the active pattern T11 of the first transistor, the active pattern T31 of the third transistor, and the active pattern T51 of the fifth transistor are of an integral structure connected to each other. The active pattern T21 of the second transistor and the active pattern T41 of the fourth transistor are of an integral structure connected to each other. The active pattern T11 of the first transistor and the active pattern T21 of the second transistor are arranged at intervals.

In the exemplary implementation, as shown in FIG. 11, in the first direction D1, the integrated structure of the active pattern T21 of the second transistor and the active pattern T41 of the fourth transistor of the present sub-pixel is located on a side of the integral structure of the active pattern T11 of the first transistor, the active pattern T31 of the third transistor and the active pattern T51 of the fifth transistor close to a previous column of sub-pixels.

In an exemplary implementation, as shown in FIG. 11, in the second direction D2, the active pattern T11 of the first transistor of the present sub-pixel may be located on a side of the active pattern T31 of the third transistor close to the previous row of sub-pixels, and the active pattern T51 of the fifth transistor of the present sub-pixel may be located on a side of the active pattern T31 of the third transistor close to the next row of sub-pixels. The active pattern T21 of the second transistor of the present sub-pixel may be located on a side of the active pattern T41 of the fourth transistor close the previous row of sub-pixels.

In an exemplary implementation, as shown in FIG. 11, a shape of the active pattern T21 of the second transistor may be a " Γ " shape.

In an exemplary implementation, as shown in FIG. 11, a shape of the active pattern T41 of the fourth transistor may be an "L" shape.

In an exemplary implementation, as shown in FIG. 11, a shape of the integral structure of the active pattern T21 of the second transistor and the active pattern T41 of the fourth transistor may be a "[" shape, of which an opening faces the integral structure of the active pattern T11 of the first transistor, the active pattern T31 of the third transistor and the active pattern T51 of the fifth transistor.

In an exemplary implementation, as shown in FIG. 11, the integral structure of the active pattern T11 of the first transistor, the active pattern T31 of the third transistor, and the active pattern T51 of the fifth transistor is located within an opening of the integral structure of the active pattern T21 of the second transistor and the active pattern T41 of the fourth transistor.

In an exemplary implementation, as shown in FIG. 11, shapes of main body portions of the active pattern T11 of the first transistor, the active pattern T31 of the third transistor, and the active pattern T51 of the fifth transistor may be strip shapes extending along the second direction D2. The integral structure of the active pattern T11 of the first transistor, the active pattern T31 of the third transistor, and the active pattern T51 of the fifth transistor extends along the second direction D2.

In an exemplary implementation, an active pattern of each transistor may include a first region, a second region, and a channel region located between the first region and the second region. Herein, the first region and the second region are made to be conductive after the substantially first conductive layer is formed, so they may also be called conductive regions. In an exemplary implementation, a second region T11-2 of the active pattern T11 of the first transistor may simultaneously serve as a second region T31-2 of the active pattern T31 of the third transistor, a second region T21-2 of the active pattern T21 of the second transistor may simultaneously serve as a second region T41-2 of the active pattern T41 of the fourth transistor, and a first region T31-1 of the active pattern T31 of the third transistor may simultaneously serve as a second region T51-2 of the active pattern T51 of the fifth transistor. A first region T11-1 of the active pattern T11 of the first transistor, a first region T21-1 of the active pattern T21 of the second transistor, a first region T41-1 of the active pattern T41 of the fourth transistor, and a first region T51-1 of the active pattern T51 of the fifth transistor may be provided separately.

In an exemplary implementation, as shown in FIG. 11, the second region T21-2 of the active pattern T21 of the second transistor may be referred to as a first conductive region T21A of the active pattern T21 of the second transistor, and the first region T21-1 of the active pattern T21 of the second transistor may be referred to as a second conductive region T21B of the active pattern T21 of the second transistor, wherein the first conductive region T21A extends along the second direction D2, and the second conductive region T21B extends along the first direction D1.

In an exemplary implementation, as shown in FIG. 11, the second region T41-2 of the active pattern T41 of the fourth transistor may be referred to as a third conductive region T41A of the active pattern T41 of the fourth transistor, and the first region T41-1 of the active pattern T41 of the fourth transistor may be referred to as a fourth conductive region T41B of the active pattern T41 of the fourth transistor, wherein the third conductive region T41A extends along the second direction D2, and the fourth conductive region T41B extends along the first direction D1.

In an exemplary implementation, as shown in FIG. 11, the third conductive region T41A is connected to the first conductive region T21A.

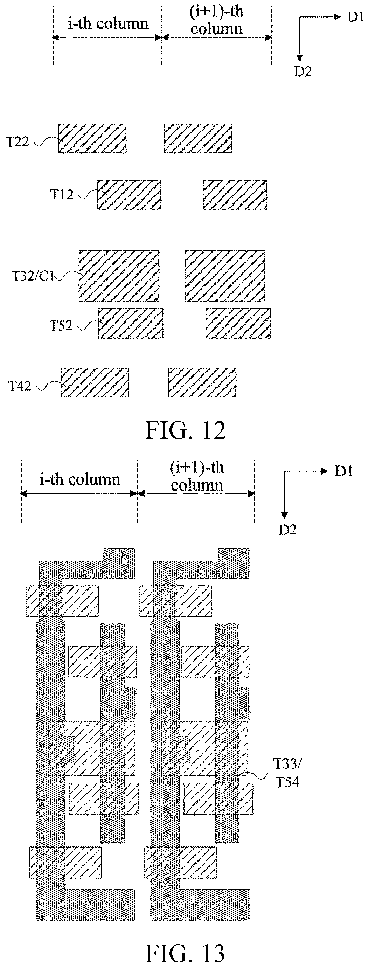

(2) Forming a pattern of a first conductive layer. In an exemplary implementation, forming the pattern of the first conductive layer may include: a second insulation thin film and a first conductive thin film are sequentially deposited on the base substrate on which the aforementioned patterns are formed, and the first conductive thin film is patterned through a patterning process to form a second insulation layer that covers the pattern of the semiconductor layer, and a pattern of a first conductive layer disposed on the second insulation layer, as shown in FIGS. 12 and 13, wherein FIG. 12 is a schematic diagram of a pattern of a first conductive layer, and FIG. 13 is a schematic diagram after a pattern of a first conductive layer is formed. In an exemplary implementation, the first conductive layer may be referred to as a first gate metal (GATE1) layer.

In an exemplary implementation, as shown in FIGS. 12 and 13, the pattern of the first conductive layer may at least include: a gate electrode T12 of the first transistor, a gate electrode T22 of the second transistor, a gate electrode T32 of the third transistor, a gate electrode T42 of the fourth transistor, a gate electrode T52 of the fifth transistor, and a first electrode plate C1 of the capacitor, which are located in at least one sub-pixel.

In an exemplary implementation, the first electrode plate C1 may also serve as the gate electrode T32 of the third transistor T3.

In an exemplary implementation, a shape of the first electrode plate C1 may be a rectangle shape, and an orthographic projection of the first electrode plate C1 on the base substrate is at least partially overlapped with orthographic projections of the active pattern of the third transistor, the first conductive region and the third conductive region on the base substrate.

In an exemplary implementation, a shape of the gate electrode T12 of the first transistor is a strip shape extending along the first direction D1.

In an exemplary implementation, a shape of the gate electrode T22 of the second transistor is a strip shape extending along the first direction D1.

In an exemplary implementation, a shape of the gate electrode T42 of the fourth transistor is a strip shape extending along the first direction D1.

In an exemplary implementation, a shape of the gate electrode T52 of the fifth transistor is a strip shape extending along the first direction D1.

In an exemplary implementation, a length of the integral structure of the gate electrode T32 of the third transistor and the first electrode plate C1 of the capacitor along the second direction D2 is larger than a length of any one of the gate electrode T12 of the first transistor, the gate electrode T22 of the second transistor, the gate electrode T42 of the fourth transistor and the gate electrode T52 of the fifth transistor along the second direction D2.

In an exemplary implementation, after the pattern of the first conductive layer is formed, a conductorization processing may be performed on the semiconductor layer by using the first conductive layer as a shield, the semiconductor layer in a region shielded by the first conductive layer forms a channel region of the active pattern of the first transistor to a channel region of the active pattern of the fifth transistor, and the semiconductor layer in a region not shielded by the first conductive layer is made to be conductorized, that is, first regions and second regions of the active pattern of the first transistor to the active pattern of the fifth transistor are all made to be conductorized. A first region T31-1 of the active pattern T31 of the third transistor (also a second region T51-2 of the active pattern T51 of the fifth transistor) after conductorization may be reused as a first electrode T33 of the third transistor, and a second electrode T54 of the fifth transistor.

In an exemplary implementation, the gate electrode T12 of the first transistor is provided across the active pattern of the first transistor, the gate electrode T22 of the second transistor is provided across the active pattern of the second transistor, the gate electrode T32 of the third transistor is provided across the active pattern of the third transistor, the gate electrode T42 of the fourth transistor is provided across the active pattern of the fourth transistor, and the gate electrode T52 of the fifth transistor is provided across the active pattern of the fifth transistor, that is, an extension direction of the gate electrode and an extension direction of the active layer of at least one transistor are perpendicular to each other.

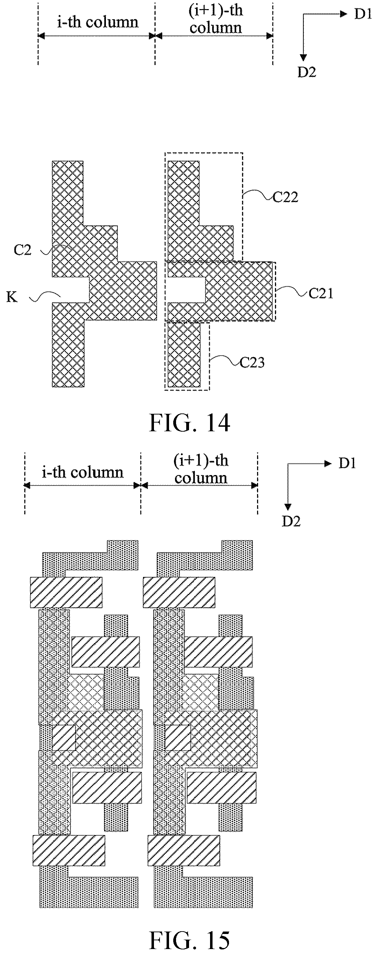

(3) Forming the pattern of the second conductive layer, which includes: depositing a third insulation thin film and a second conductive thin film sequentially on the base substrate on which the aforementioned patterns are formed, patterning the third insulation thin film and the second conductive thin film through a patterning process to form a third insulation layer and the pattern of the second conductive layer on the third insulation layer, as shown in FIGS. 14 and 15, wherein FIG. 14 is a schematic diagram of a pattern of a second conductive layer, and FIG. 15 is a schematic diagram after a pattern of a second conductive layer is formed. In an exemplary implementation, the second conductive layer may be referred to as a second gate metal (GATE2) layer.

In an exemplary implementation, as shown in FIGS. 14 and 15, the pattern of the second conductive layer may at least include a second electrode plate C2 of the capacitance located in at least one sub-pixel.

In an exemplary implementation, as shown in FIGS. 14 and 15, the second electrode plate C2 may include a capacitor main body portion C21, a first capacitor connection portion C22, and a second capacitor connection portion C23. Herein, the first capacitor connection portion C22 and the second capacitor connection portion C23 are located on both sides of the capacitor main body portion C21, respectively, and are connected to the capacitor main body portion C21, respectively.

In an exemplary implementation, as shown in FIGS. 14 and 15, the first capacitor connection portion C22 of the present sub-pixel may be located on a side of the capacitor main body portion C21 close to the previous row of sub-pixels, and the second capacitor connection portion C23 of the present sub-pixel may be located on a side of the capacitor main body portion C21 close to the next row of sub-pixels.

In the exemplary implementation, as shown in FIGS. 14 and 15, a length of the first capacitor connection portion C22 along the first direction D1 is larger than a length of the second capacitor connection portion C23 along the first direction D1, and a length of the capacitor main body portion C21 along the first direction D1 is larger than a length of the first capacitor connection portion C22 along the first direction D1.

In the exemplary implementation, as shown in FIGS. 14 and 15, a boundary of the first capacitor connection portion C22 close to the previous column of sub-pixels is flush with a boundary of the second capacitor connection portion C22 close to the previous column of sub-pixels, and is flush with a boundary of the capacitor main body portion C21 close to the previous column of sub-pixels.

In an exemplary implementation, as shown in FIG. 15, a shape of the capacitor main body portion C21 may be a square provided with the groove K. The groove K is provided on a side of the capacitor main body portion C21 of the sub-pixel close to the previous column of sub-pixels. The groove K exposes the first electrode plate (also the gate electrode of the third transistor) and the second electrode of the second transistor (also the second electrode of the fourth transistor).

In an exemplary implementation, as shown in FIG. 15, within the same sub-pixel, an opening direction of the groove K is located on a side away from the second active layer.

In an exemplary implementation, as shown in FIGS. 14 and 15, a shape of the groove K may be a square or other shapes, which is not limited in the present disclosure.

In an exemplary implementation, as shown in FIG. 15, an orthographic projection of the capacitor main body portion C21 on the base substrate is at least partially overlapped with orthographic projections of the first electrode plate of the capacitor (also the gate electrode of the third transistor), at least a portion of regions of the first conductive region and the third conductive region on the base substrate.

In an exemplary implementation, as shown in FIGS. 14 and 15, a shape of the first capacitor connection portion C22 may be an "L" shape.

In an exemplary implementation, as shown in FIGS. 14 and 15, a shape of the second capacitor connection portion C23 may be a strip shape extending along the second direction D2.

In an exemplary implementation, as shown in FIG. 15, an orthographic projection of any of the first capacitor connection portion C22 and the second capacitor connection portion C23 on the base substrate may be at least partially overlapped with orthographic projections of the first conductive region and the third conductive region on the base substrate, and is not overlapped with an orthographic projection of the first electrode plate of the capacitor (also the gate electrode of the third transistor) on the base substrate.

In an exemplary implementation, a length of any of the first capacitor connection C22 and the second capacitor connection C23 along the first direction D1 may be greater than or equal to a length of the second electrode of the second transistor (also the second electrode of the fourth transistor) along the first direction D1.

In an exemplary implementation, along the second direction, a distance between an orthographic projection of the gate electrode of the second transistor on the base substrate and an orthographic projection of the second electrode plate of the capacitor on the base substrate is less than a distance between the orthographic projection of the gate electrode of the second transistor on the base substrate and an orthographic projection of the gate electrode of the first transistor on the base substrate; and a distance between an orthographic projection of the gate electrode of the fourth transistor on the base substrate and the orthographic projection of the second electrode plate of the capacitor on the base substrate is less than a distance between the orthographic projection of the gate electrode of the fourth transistor on the base substrate and an orthographic projection of the gate electrode of the fifth transistor on the base substrate.

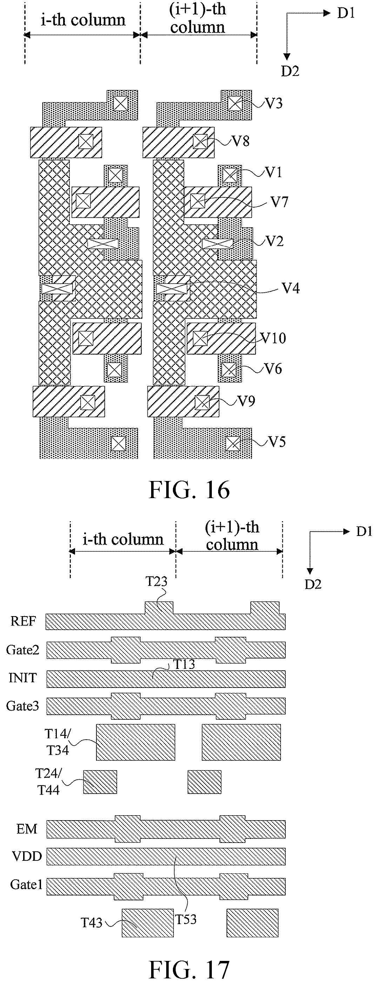

(4) Forming the pattern of the fourth insulation layer, which includes: depositing a fourth insulation thin film on the base substrate on which the aforementioned patterns are formed, and patterning the fourth insulation thin film through a patterning process to form the pattern of the fourth insulation layer covering the aforementioned patterns. The fourth insulation layer is provided with a plurality of patterns of via holes, as shown in FIG. 16, which is a schematic diagram after a pattern of a fourth insulation layer is formed.

In an exemplary implementation, as shown in FIG. 16, the plurality of via holes of the fourth insulation layer at least include a first via hole V1, a second via hole V2, a third via hole V3, a fourth via hole V4, a fifth via hole V5, a sixth via hole V6, a seventh via hole V7, an eighth via hole V8, a ninth via hole V9, and a tenth via hole V10, which are located in at least one sub-pixel.

In an exemplary implementation, as shown in FIG. 16, an orthographic projection of the first via hole V1 on the base substrate is within a range of an orthographic projection of a first region of the active pattern of the first transistor on the base substrate, the second insulation layer and the third insulation layer within the first via hole V1 are etched away to expose a surface of the first region of the active pattern of the first transistor, and the first via hole V1 is configured such that the initial signal line INIT formed subsequently is connected with the first region of the active pattern of the first transistor through the first via hole V1.

In an exemplary implementation, as shown in FIG. 16, an orthographic projection of the second via hole V2 on the base substrate is within a range of orthographic projections of the second region of the active pattern of the first transistor (also the second region of the active pattern of the third transistor) and the second electrode plate of the capacitor on the base substrate, a portion of the second insulation layer and a portion of the third insulation layer within the second via hole V2 are etched away to expose surfaces of the second region of the active pattern of the first transistor (also the second region of the active pattern of the third transistor) and the second electrode plate of the capacitor, and the second via hole V2 is configured such that the first connection electrode formed subsequently is connected to the second region of the active pattern of the first transistor (also the second region of the active pattern of the third transistor) and the second electrode plate of the capacitor through the second via hole V2.

In an exemplary implementation, as shown in FIG. 16, an orthographic projection of the second via hole V3 on the base substrate is within a range of an orthographic projection of a first region of the active pattern of the second transistor on the base substrate, the second insulation layer and the third insulation layer within the third via hole V3 are etched away to expose a surface of the first region of the active pattern of the second transistor, and the third via hole V3 is configured such that the reference signal line formed subsequently is connected with the first region of the active pattern of the second transistor through the third via hole V3.

In an exemplary implementation, as shown in FIG. 16, an orthographic projection of the fourth via hole V4 on the base substrate is within a range of orthographic projections of the second region of the active pattern of the second transistor (also the second region of the active pattern of the fourth transistor) and the first electrode plate of the capacitor on the base substrate, a portion of the second insulation layer and a portion of the third insulation layer within the fourth via hole V4 are etched away to expose surfaces of the second region of the active pattern of the second transistor (also the second region of the active pattern of the fourth transistor) and the first electrode plate of the capacitor, and the fourth via hole V4 is configured such that the second connection electrode formed subsequently is connected to the second region of the active pattern of the second transistor (also the second region of the active pattern of the fourth transistor) and the first electrode plate of the capacitor through the fourth via hole V4.

In an exemplary implementation, as shown in FIG. 16, an orthographic projection of the fifth via hole V5 on the base substrate is within a range of an orthographic projection of the first region of the active pattern of the fourth transistor on the base substrate, the second insulation layer and the third insulation layer within the fifth via hole V5 are etched away to expose a surface of the first region of the active pattern of the fourth transistor, and the fifth via hole V5 is configured such that the first electrode of the fourth transistor subsequently formed is connected with the first region of the active pattern of the fourth transistor through the fifth via hole V5.

In an exemplary implementation, as shown in FIG. 16, an orthographic projection of the sixth via hole V6 on the base substrate is within a range of an orthographic projection of a first region of the active pattern of the fifth transistor on the base substrate, the second insulation layer and the third insulation layer within the sixth via hole V6 are etched away to expose a surface of the first region of the active pattern of the fifth transistor, and the sixth via hole V6 is configured such that the first power supply line subsequently formed is connected with the first region of the active pattern of the fifth transistor through the sixth via hole V6.

In an exemplary implementation, as shown in FIG. 16, an orthographic projection of the seventh via hole V7 on the base substrate is within a range of an orthographic projection of the gate electrode of the first transistor on the base substrate, the third insulation layer within the seventh via hole V7 is etched away to expose a surface of the gate electrode of the first transistor, and the seventh via hole V7 is configured such that the third scan signal line formed subsequently is connected to the gate electrode of the first transistor through the via hole V7.

In an exemplary implementation, as shown FIG. 16, an orthographic projection of the eighth via hole V8 on the base substrate is within a range of an orthographic projection of the gate electrode of the second transistor on the base substrate, the third insulation layer within the eighth via hole V8 is etched away to expose a surface of the gate electrode of the second transistor, and the eighth via hole V8 is configured such that the second scan signal line formed subsequently is connected with the gate electrode of the second transistor through the eighth via hole V8.

In an exemplary implementation, as shown in FIG. 16, an orthographic projection of the ninth via hole V9 on the base substrate is within a range of an orthographic projection of the gate electrode of the fourth transistor on the base substrate, the third insulation layer within the ninth via hole V9 is etched away to expose a surface of the gate electrode of the fourth transistor, and the ninth via hole V9 is configured such that a first scanning signal line to be formed subsequently is connected to the gate electrode of the fourth transistor through the ninth via hole V9.

In an exemplary implementation, as shown in FIG. 16, an orthographic projection of the tenth via hole V10 on the base substrate is within a range of an orthographic projection of the gate electrode of the fifth transistor on the base substrate, the third insulation layer within the tenth via hole V10 is etched away to expose a surface of the gate electrode of the fifth transistor, and the tenth via hole V10 is configured such that the light emitting signal line formed subsequently is connected to the gate electrode of the fifth transistor through the via hole V7.

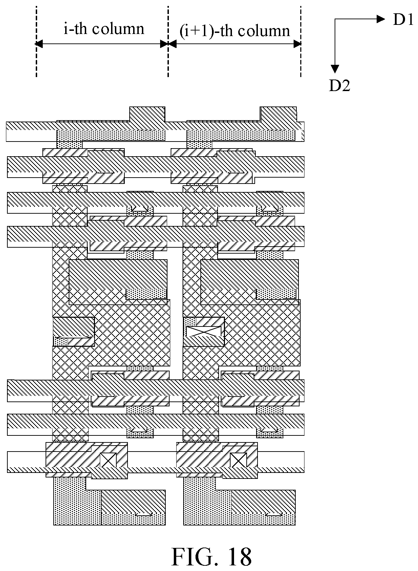

(5) Forming the pattern of the third conductive layer, which includes: depositing a third conductive thin film on the base substrate on which the aforementioned patterns are formed, and patterning the third conductive thin film through a patterning process to form a pattern of a third conductive layer on the fourth insulation layer, as shown in FIGS. 17 and 18, wherein FIG. 17 is a schematic diagram of the pattern of a third conductive layer, and FIG. 18 is a schematic diagram after a pattern of a third conductive layer is formed. In an exemplary implementation, the third conductive layer may be referred to as a first source-drain metal (SD1) layer.

In an exemplary implementation, as shown in FIGS. 17 and 18, the pattern of the third conductive layer may at least include: a first scan signal line Gate1, a second scan signal line Gate2, a third scan signal line Gate3, a light emitting signal line EM, a reference signal line REF, a first power supply line VDD, an initial signal line INIT, and a second electrode T14 of the first transistor, a second electrode T24 of the second transistor, a second electrode T34 of the third transistor, a first electrode T43 and a second electrode T44 of the fourth transistor, which are located in at least one sub-pixel.

In an exemplary implementation, as shown in FIGS. 17 and 18, a shape of the reference signal line REF may be a line shape in which the main body portion extends along the first direction D1. A region where the reference signal line REF is overlapped with the active pattern of the second transistor serves as the first electrode T23 of the second transistor.

In an exemplary implementation, as shown in FIGS. 17 and 18, the reference signal line REF is connected to the first region of the active pattern of the second transistor through the third via hole.

In the exemplary implementation, as shown in FIGS. 17 and 18, the second scan signal line Gate2 is located between the reference signal line REF and the initial signal line INIT. A shape of the second scan signal line Gate2 may be a line shape in which the main body portion extends along the first direction D1.

In an exemplary implementation, as shown in FIGS. 17 and 18, an orthographic projection of the second scan signal line Gate2 on the base substrate is at least partially overlapped with an orthographic projection of the gate electrode of the second transistor on the base substrate.

In an exemplary implementation, as shown in FIGS. 17 and 18, the second scan signal line Gate2 is connected to the gate electrode of the second transistor through the eighth via hole.

In an exemplary implementation, as shown in FIGS. 17 and 18, the initial signal line INIT is located on a side of the second scan signal line Gate2 away from the reference signal line REF. A shape of the initial signal line INIT may be a line shape in which the main body portion extends along the first direction D1. The region where the initial signal line INIT is overlapped with the active pattern of the first transistor serves as the first electrode T13 of the first transistor.

In an exemplary implementation, as shown in FIGS. 17 and 18, the initial signal line INIT is connected to the first region of the active pattern of the first transistor through the first via hole.

In the exemplary implementation, as shown in FIGS. 17 and 18, the third scan signal line Gate3 is located on a side of the initial signal line INIT away from the second scan signal line Gate2. A shape of the third scan signal line Gate3 may be a line shape in which the main body portion extends along the first direction D1.

In an exemplary implementation, as shown in FIGS. 17 and 18, an orthographic projection of the third scan signal line Gate3 on the base substrate is at least partially overlapped with an orthographic projection of the gate electrode of the first transistor on the base substrate.

In an exemplary implementation, as shown in FIGS. 17 and 18, the third scan signal line Gate3 is connected to the gate electrode of the first transistor through the seventh via hole.

In the exemplary implementation, as shown in FIGS. 17 and 18, the light emitting signal line EM is located on a side of the third scan signal line Gate3 away from the initial signal line INIT. A shape of the light emitting signal line EM may be a line shape in which the main body portion extends along the first direction D1.

In an exemplary implementation, as shown in FIGS. 17 and 18, an orthographic projection of the light emitting signal line EM on the base substrate is at least partially overlapped with an orthographic projection of the gate electrode of the fifth transistor on the base substrate.

In the exemplary implementation, as shown in FIGS. 17 and 18, the light emitting signal line EM is connected to the gate electrode of the fifth transistor through the tenth via hole.

In the exemplary implementation, as shown in FIGS. 17 and 18, the first power supply line VDD is located on a side of the light emitting signal line EM away from the third scan signal line Gate3. A shape of the first power supply line VDD may be a line shape in which the main body portion extends along the first direction D1. A region where the first power supply line VDD is overlapped with the active pattern of the fifth transistor serves as the first electrode T13 of the fifth transistor.

In an exemplary implementation, as shown in FIGS. 17 and 18, the first power supply line VDD is connected to the first region of the active pattern of the fifth transistor through the sixth via hole.

In the exemplary implementation, as shown in FIGS. 17 and 18, the first scan signal line Gate1 is located on a side of the first power supply line VDD away from the light emitting signal line EM. A shape of the first scan signal line Gate1 may be a line shape in which the main body portion extends along the first direction D1.

In an exemplary implementation, as shown in FIGS. 17 and 18, an orthographic projection of the first scan signal line Gate1 on the base substrate is at least partially overlapped with an orthographic projection of the gate electrode of the fourth transistor on the base substrate.

In an exemplary implementation, as shown in FIGS. 17 and 18, the first scan signal line Gate1 is connected to the gate electrode of the fourth transistor through the ninth via hole.

In the exemplary implementation, as shown in FIGS. 17 and 18, the second electrode T14 of the first transistor and the second electrode T34 of the third transistor are of an integral structure, and are located between the third scan signal line Gate3 and the light emitting signal line EM. A shape of the integral structure of the second electrode T14 of the first transistor and the second electrode T34 of the third transistor may be a strip shape extending along the first direction D1.

In an exemplary implementation, as shown in FIGS. 17 and 18, an orthographic projection of the integral structure of the second electrode T14 of the first transistor and the second electrode T34 of the third transistor on the base substrate is at least partially overlapped with an orthographic projection of the second electrode plate of the capacitor on the base substrate.

In an exemplary implementation, as shown in FIGS. 17 and 18, the second electrode T14 of the first transistor (also the second electrode T34 of the third transistor) is connected to the second region of the active pattern of the first transistor (also the second region of the active pattern of the third transistor) and the second electrode plate of the capacitor through the second via hole.

In the exemplary implementation, as shown in FIGS. 17 and 18, the second electrode T24 of the second transistor and the second electrode T44 of the fourth transistor are of an integral structure, and are located between the second electrode T14 of the first transistor (also the second electrode T34 of the third transistor) and the light emitting signal line EM. The second electrode T24 of the second transistor (also the second electrode T44 of the fourth transistor) may be in a strip shape extending along the first direction D1.

In an exemplary implementation, as shown in FIGS. 17 and 18, an orthographic projection of the second electrode T24 of the second transistor (also the second electrode T44 of the fourth transistor) on the base substrate is within an orthographic projection of a groove of the second electrode plate of the capacitor on the base substrate.

In an exemplary implementation, as shown in FIGS. 17 and 18, the second electrode T24 of the second transistor (also the second electrode T44 of the fourth transistor) is connected to the second region of the active pattern of the second transistor (also the second region of the active pattern of the fourth transistor) and the first electrode plate of the capacitor through the fourth via hole.

In the exemplary implementation, as shown in FIGS. 17 and 18, the first electrode T43 of the fourth transistor is located on a side of the first scan signal line Gate1 away from the first power supply line VDD. A shape of the first electrode VL3 of the fourth transistor may be a strip shape extending along the first direction D1.

In an exemplary implementation, as shown in FIGS. 17 and 18, an orthographic projection of the first electrode T43 of the fourth transistor on the base substrate is within an orthographic projection of the active pattern of the fourth transistor on the base substrate.

In an exemplary implementation, as shown in FIGS. 17 and 18, the first electrode T43 of the fourth transistor is connected to the first region of an active pattern of the fourth transistor through the fifth via hole.

In an exemplary implementation, the first scan signal line Gate1, the second scan signal line Gate2, the third scan signal line Gate3, the light emitting signal line EM, the reference signal line REF, the first power supply line VDD, and the initial signal line INIT may be designed with equal width or may be designed with unequal width, may be straight lines or may be polygonal lines, which can not only facilitate a layout of a pixel structure, but also reduce a parasitic capacitance between signal lines, and the present disclosure is not limited here.

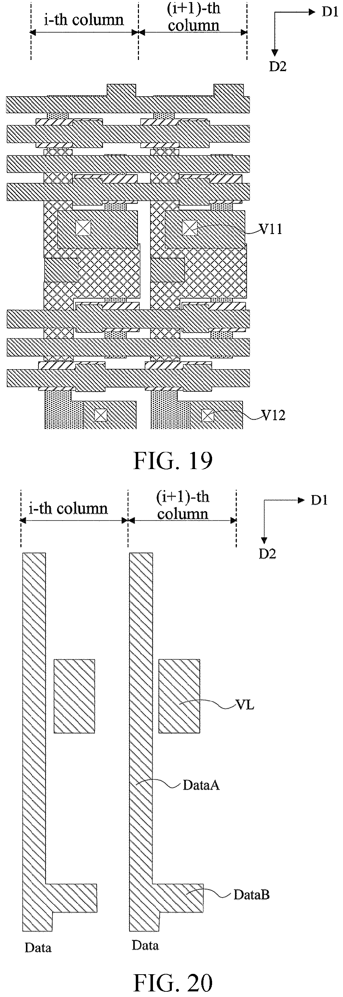

(6) Forming the pattern of the fifth insulation layer, which includes: coating a first planarization thin film on the base substrate on which the aforementioned patterns are formed, patterning the first planarization thin film through a patterning process to form a first planarization layer, depositing a fifth insulation thin film on the first planarization layer, and patterning the fifth insulation thin film through a patterning process to form the pattern of the fifth insulation layer covering the aforementioned pattern, and the pattern of the fifth insulation layer is provided with a plurality of patterns of the via holes, as shown in FIG. 19, which is a schematic diagram after a pattern of a fifth insulation layer is formed.

In an exemplary implementation, as shown in FIG. 19, the plurality of via holes of the pattern of the fifth insulation layer at least include an eleventh via hole V11 and a twelfth via hole V12, which are located in at least one sub-pixel.

In an exemplary implementation, as shown in FIG. 19, an orthographic projection of the eleventh via hole V11 on the base substrate is within an orthographic projection of the second electrode T14 of the first transistor (also the second electrode T34 of the third transistor) on the base substrate, the first planarization layer within the eleventh via hole V11 is etched away to expose a surface of the second electrode T14 of the first transistor (also the second electrode T34 of the third transistor), and the eleventh via hole V11 is configured such that the anode connection electrode formed subsequently is connected to the second electrode T14 of the first transistor (also the second electrode T34 of the third transistor) through the eleventh via hole V11.

In an exemplary implementation, as shown in FIG. 19, an orthographic projection of the twelfth via hole V12 on the base substrate is within a range of an orthographic projection of the first electrode of the fourth transistor on the base substrate, the first planarization layer within the twelfth via hole V12 is etched away to expose a surface of the first electrode of the fourth transistor, and the twelfth via hole V12 is configured such that the data signal line formed subsequently is connected to the first electrode of the fourth transistor through the twelfth via hole V12.

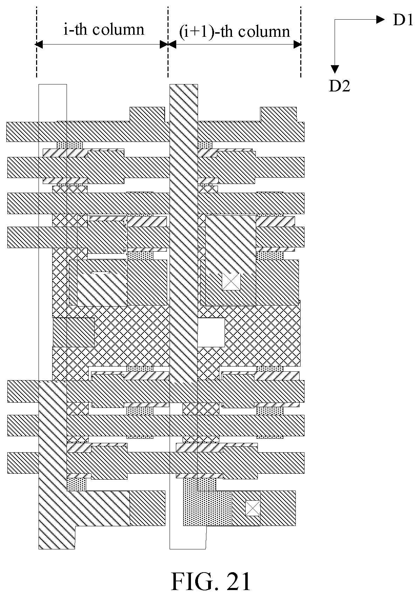

(7) Forming the pattern of the fourth conductive layer, which includes: depositing a fourth conductive thin film on the base substrate on which the aforementioned patterns are formed, and patterning the fourth conductive thin film through a patterning process to form a pattern of a fourth conductive layer, as shown in FIGS. 20 and 21, wherein FIG. 20 is a schematic diagram of a pattern of a fourth conductive layer, and FIG. 21 is a schematic diagram after a pattern of a fourth conductive layer is formed. In an exemplary implementation, the fourth conductive layer may be referred to as a second source-drain metal (SD2) layer.

In an exemplary implementation, as shown in FIGS. 20 and 21, the pattern of the fourth conductive layer may at least include a data signal line Data and an anode connection electrode VL.

In the exemplary implementation, as shown in FIGS. 20 and 21, the anode connection electrode VL of the present sub-pixel is located on a side of the data signal line connected to the present sub-pixel close to the next column of sub-pixels. The anode connection electrode VL has a strip shape extending along the second direction D2.

In an exemplary implementation, as shown in FIGS. 20 and 21, an orthographic projection of the anode connection electrode VL on the base substrate is at least partially overlapped with orthographic projections of the second electrode of the first transistor (also the second electrode of the third transistor) and the third scan signal line on the base substrate.

In an exemplary implementation, as shown in FIGS. 20 and 21, the anode connection electrode VL is connected to the second electrode of the first transistor (also the second electrode of the third transistor) through the eleventh via hole. Since the second electrode of the first transistor (also the second electrode of the third transistor) is connected to the second electrode plate of the capacitor, the anode connection electrode VL is connected to the second region of the active pattern of the first transistor (also the second region of the active pattern of the third transistor) and the second electrode plate of the capacitor through the second electrode of the first transistor (also the second electrode of the third transistor).

In an exemplary implementation, as shown in FIGS. 20 and 21, the data signal line Data extends at least partially along the second direction D2.

In an exemplary implementation, as shown in FIGS. 20 and 21, an orthographic projection of the data signal line Data on the base substrate is at least partially overlapped with orthographic projections of the first conductive region, the third conductive region, the fourth conductive region and the second electrode plate of the capacitor on the base substrate.

In an exemplary implementation, as shown in FIGS. 20 and 21, the data signal line Data includes a data signal main body line DataA and a plurality of data signal connection lines DataB. Herein, the data signal main body line DataA extends along the second direction D2, and the data signal connection line DataB extends along the first direction D1.

In an exemplary implementation, an orthographic projection of the data signal main body line DataA on the base substrate is at least partially overlapped with orthographic projections of the first conductive region, the third conductive region and the second electrode plate of the capacitor on the base substrate, and an orthographic projection of the data signal connection line DataB on the base substrate is at least partially overlapped with an orthographic projection of the fourth conductive region on the base substrate.

In an exemplary implementation, as shown in FIGS. 20 and 21, the data signal line Data is connected to the first electrode of the fourth transistor through the twelfth via hole. Herein, the data signal connection line DataB of the data signal line Data is connected to the first electrode of the fourth transistor through the twelfth via hole.

(8) Forming the pattern of the second planarization layer, which includes: depositing a sixth insulation thin film on the base substrate on which the patterns are formed, patterning the sixth insulation thin film through a patterning process to form a sixth insulation layer covering the aforementioned pattern, coating the second planarization thin film on the sixth insulation layer; patterning the second planarization thin film through a patterning process to form the pattern of the second planarization layer covering the aforementioned pattern.

The pattern of the second planarization layer at least includes a thirteenth via hole. An orthographic projection of the thirteenth via hole on the base substrate is within a range of an orthographic projection of the anode connection electrode on the base substrate, the sixth insulation layer within the thirteenth via hole is etched away to expose a surface of the anode connection electrode, and the thirteenth via hole is configured such that the anode of the light emitting device formed subsequently is connected to the anode connection electrode through the thirteenth via hole.

So far, the driving structure layer has been prepared on the base substrate. **In** a plane parallel to the display substrate, the driving structure layer may include a plurality of pixel circuits, and a pixel circuit is connected to a first scan signal line, a second scan signal line, a third scan signal line, a light emitting signal line, a reference signal line, an initial signal line, a data signal line, and a first power supply line. The driving structure layer may be arranged on the base substrate. The driving structure layer may include a first insulation layer, a semiconductor layer, a second insulation layer, a first conductive layer, a third insulation layer, a second conductive layer, a fourth insulation layer, a third conductive layer, a first planarization layer, a fifth insulation layer, a fourth conductive layer, a sixth insulation layer, and a second planarization layer, which are arranged sequentially on the base substrate.

In an exemplary implementation, the semiconductor layer may be an amorphous silicon layer, a polycrystalline silicon layer, or may be a metal oxide layer. Herein, the metal oxide layer may use an oxide including indium and tin, an oxide including tungsten and indium, an oxide including tungsten, indium and zinc, an oxide including titanium and indium, an oxide including titanium, indium and tin, an oxide including indium and zinc, an oxide including silicon, indium and tin, or an oxide including indium or gallium and zinc. The metal oxide layer may be a single layer, a double-layer, or a multi-layer.

In an exemplary implementation, the first conductive layer, the second conductive layer, the third conductive layer, and the fourth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo.

In an exemplary implementation, the first insulation layer, the second insulation layer, the third insulation layer, the fourth insulation layer, the fifth insulation layer, and the sixth insulation layer may be made of any one or more of Silicon Oxide (SiOx), Silicon Nitride (SiNx), and Silicon Oxynitride (SiON), and may be a single layer, a multi-layer, or a composite layer.

In an exemplary implementation, the first planarization layer and the second planarization layer may be made of an organic material, such as resin or the like.

In an exemplary implementation, after preparation of the driving structure layer is completed, a light emitting structure layer is prepared on the driving structure layer, and a preparation process of the light emitting structure layer may include following operations.

(9) Forming a pattern of a fifth conductive layer. In an exemplary implementation, forming the pattern of the fifth conductive layer may include: depositing a fifth conductive thin film on the base substrate on which the aforementioned patterns are formed, patterning the fifth conductive thin film through a patterning process to form a fifth conductive layer arranged on the second planarization layer, and the fifth conductive layer at least includes a plurality of patterns of the first electrodes.

In an exemplary implementation, the pattern of the fifth conductive layer may include a plurality of patterns of the first electrodes. The plurality of patterns of the first electrodes may include the first electrode of the first light emitting device, the first electrode of the second light emitting device, the first electrode of the third light emitting device, and the first electrode of the fourth light emitting device, wherein the first electrode of the first light emitting device is located in the red sub-pixel emitting red light, the first electrode of the second light emitting device is located in the blue sub-pixel emitting blue light, the first electrode of the third light emitting device is located in a first green sub-pixel emitting green light, and the first electrode of the fourth light emitting device is located in a second green sub-pixel emitting green light.

In an exemplary implementation, the first electrode of the first light emitting device and the first electrode of the second light emitting device may be alternately arranged along the second direction, and the first electrode of the third light emitting device and the first electrode of the fourth light emitting device may be alternately arranged along the second direction. Alternatively, the first electrode of the first light emitting device and the first electrode of the second light emitting device may be alternately arranged along the first direction, and the first electrode of the third light emitting device and the first electrode of the fourth light emitting device may be alternately arranged along the first direction.

In an exemplary implementation, the first electrode of the first light emitting device, the first electrode of the second light emitting device, the first electrode of the third light emitting device, and the first electrode of the fourth light emitting device may respectively be connected to the connection electrode of the sub-pixels where the light emitting devices are located through via holes that expose the connection electrodes of the sub-pixels where the light emitting devices are located.

In an exemplary implementation, four sub-pixels in a pixel unit may have a same or different anode shapes and areas.

In an exemplary implementation, at least one of the first electrode of the first light emitting device, the first electrode of the second light emitting device, the first electrode of the third light emitting device, and the first electrode of the fourth light emitting device may include an anode main portion and an anode connection portion connected with each other, wherein the anode connection portion is connected with the connection electrode.

In an exemplary implementation, the first electrode of the first light emitting device may include a first anode main portion and a first anode connection portion connected with each other, a shape of the first anode main portion may be a rectangular shape in which corners may be provided with arc-shaped chamfers, and a shape of the first anode connection portion may be a strip shape. In an exemplary implementation, the first electrode of the second light emitting device may include a second anode main portion and a second anode connection portion connected with each other, a shape of the second anode main portion may be a rectangular shape in which corners may be provided with arc-shaped chamfers, and a shape of the second anode connection portion may be a strip shape. In an exemplary implementation, the first electrode of the third light emitting device may include a third anode main portion and a third anode connection portion connected with each other, a shape of the third anode main portion may be a rectangular shape in which corners may be provided with arc-shaped chamfers, and a shape of the third anode connection portion may be a strip shape. In an exemplary implementation, the first electrode of the fourth light emitting device may include a fourth anode main portion and a fourth anode connection portion connected with each other, a shape of the fourth anode main portion may be a rectangular shape in which corners may be provided with arc-shaped chamfers, and the fourth anode connection portion may be a strip shape.

In an exemplary implementation, the fifth conductive layer has a single-layer structure, such as Indium Tin Oxide (ITO) or Indium Zinc Oxide (IZO), or may have a multi-layer composite structure, such as ITO/Ag/ITO.

(10) Forming a pattern of a sixth conductive layer. In an exemplary implementation, forming the sixth conductive layer may include: coating a pixel definition thin film on the base substrate on which the aforementioned patterns are formed, depositing the pixel definition thin film on the base substrate on which the aforementioned patterns are formed, patterning the pixel definition thin film through a patterning process to form a pattern of a pixel definition layer exposing the pattern of the fifth conductive layer, coating an organic luminescent material on the base substrate on which the pattern of the pixel definition layer is formed, patterning the organic luminescent material through a patterning process to form a pattern of an organic structure layer, depositing a sixth conductive thin film on the base substrate on which the pattern of the organic material layer is formed, and patterning the sixth conductive thin film through a patterning process to form the sixth conductive layer.

In an exemplary implementation, a subsequent preparation process may include: forming an encapsulation structure layer on the sixth conductive layer, wherein the encapsulation structure layer may include a first encapsulation layer, a second encapsulation layer and a third encapsulation layer which are stacked. The first encapsulation layer and the third encapsulation layer may be made of an inorganic material, the second encapsulation layer may be made of an organic material, and the second encapsulation layer is arranged between the first encapsulation layer and the third encapsulation layer to ensure that external water vapor cannot enter the light emitting structure layer.

In an exemplary implementation, the organic structure layer may at least include: an organic light emitting layer of the light emitting device.

In an exemplary implementation, the sixth conductive layer may at least include: second electrodes (cathodes) of a plurality of light emitting devices.

In an exemplary implementation, the sixth conductive layer may be made of a metal material, such as any one or more of argentum (Ag), copper (Cu), aluminum (Al), and molybdenum (Mo), or a conductive alloy material described above, such as an Aluminum Neodymium alloy (AlNd) or a Molybdenum Niobium alloy (MoNb), and may be of a single-layer structure or a multi-layer composite structure, such as Mo/Cu/Mo.. Exemplarily, the fourth conductive layer may be of a three-layer stacked structure formed of titanium, aluminum, and titanium.

The display substrate according to the embodiment of the present disclosure may be applied to a display product with any resolution.

An embodiment of the present disclosure further provides a display apparatus including a display substrate.

The display substrate is the display substrate according to any of the aforementioned embodiments, and has similar implementation principles and implementation effects, which will not be repeated here.

In an exemplary implementation, the display apparatus may be any product or component with a display function, such as a liquid crystal panel, electronic paper, an OLED panel, an Active-Matrix Organic Light Emitting Diode (AMOLED) panel, a mobile phone, a tablet computer, a television, a display, a notebook computer, a digital photo frame, or a navigator.

The accompanying drawings of the present disclosure only involve the structures involved in the embodiments of the present disclosure, and other structures may refer to usual designs.

For the sake of clarity, a thickness and size of a layer or a micro structure are enlarged in the accompanying drawings used for describing the embodiments of the present disclosure. It may be understood that when an element such as a layer, film, region, or substrate is described as being "on" or "under" another element, the element may be "directly" located "on" or "under" the another element, or there may be an intermediate element.

Although the implementations of the present disclosure are disclosed above, the contents are only implementations used for ease of understanding of the present disclosure, but not intended to limit the present disclosure. Any of those skilled in the art of the present disclosure can make any modifications and variations in the implementation mode and details without departing from the spirit and scope of the present disclosure. However, the protection scope of the present disclosure should be subject to the scope defined by the appended claims.

## Claims

1. A display substrate, comprising: a base substrate, and a plurality of sub-pixels arranged on the base substrate, wherein at least one sub-pixel comprises: a pixel circuit which comprises: a third transistor and a plurality of transistors connected with the third transistor; a transistor comprises an active pattern, and active patterns of at least two transistors connected with a gate electrode of the third transistor are of an integral structure and are a first active layer; active patterns of at least two transistors connected with any one of a first electrode and a second electrode of the third transistor and an active pattern of the third transistor are of an integral structure and are a second active layer;

   the first active layer and the second active layer are arranged along a first direction, and at least part of the first active layer and the second active layer extends along a second direction, and the first direction intersects with the second direction; and
   a length of the first active layer along the second direction is greater than a length of the second active layer along the second direction.

2. The display substrate according to claim 1, wherein the plurality of transistors connected to the third transistor comprise: a first transistor, a second transistor, a fourth transistor, and a fifth transistor, and the first transistor to the fifth transistor are N-type transistors;

   a second electrode of the first transistor is electrically connected to a second electrode of the third transistor, a second electrode of the second transistor and a second electrode of the fourth transistor are electrically connected to a gate electrode of the third transistor, respectively, and a second electrode of the fifth transistor is electrically connected to a first electrode of the third transistor;
   an active pattern comprises a channel region and a conductive region, and the conductive region of any active pattern is located at both sides of the channel region; wherein an active pattern of the second transistor and an active pattern of the fourth transistor are a first active layer, and an active pattern of the first transistor, an active pattern of the third transistor and an active pattern of the fifth transistor are a second active layer.

3. The display substrate according to claim 2, wherein the active pattern of the first transistor and the active pattern of the fifth transistor are located on two sides of the active pattern of the third transistor, respectively, and the active pattern of the second transistor comprises a first conductive region and a second conductive region; the active pattern of the fourth transistor comprises a third conductive region and a fourth conductive region; the first conductive region and the third conductive region extend along the second direction, and the second conductive region and the fourth conductive region extend along the first direction; and the third conductive region is connected with the first conductive region.

4. The display substrate according to claim 3, wherein the second conductive region is located on a side of the first conductive region close to the second active layer, and the second conductive region and at least a portion of the active pattern of the first transistor are located on one side of an active layer centerline; the active layer centerline is a centerline of the second active layer extending along the first direction; and

the fourth conductive region is located on a side of the third conductive region close to the second active layer, and the fourth conductive region and at least a portion of the active pattern of the fifth transistor are located on the other side of the active layer centerline.

5. The display substrate according to claim 3 or 4, further comprising: a first signal line arranged on the base substrate, wherein at least a portion of the first signal line extends along the first direction, and a gate electrode of at least one transistor is arranged in a different layer from the first signal line; and

a resistivity of a film layer where the first signal line is located is smaller than a resistivity of a film layer where the gate electrode of the at least one transistor is located.

6. The display substrate according to claim 5, wherein the gate electrode of the first transistor to the gate electrode of the fifth transistor are arranged at intervals; and

a length of the gate electrode of the third transistor along the second direction is larger than a length of a gate electrode of any one of the first transistor, the second transistor, the fourth transistor and the fifth transistor along the second direction.

7. The display substrate according to claim 5 or 6, wherein the pixel circuit further comprises a capacitor, the capacitor comprises: a first electrode plate and a second electrode plate; the first electrode plate of the capacitor is located on a side of the second electrode plate of the capacitor close to the base substrate; and

an orthographic projection of the first electrode plate of the capacitor on the base substrate is at least partially overlapped with orthographic projections of the first conductive region, the active pattern of the third transistor, and the third conductive region on the base substrate.

8. The display substrate according to claim 7, wherein the first signal line comprises: a third scan signal line, an initial signal line, a first power supply line, and a light emitting signal line; the first transistor is connected to the third scan signal line and the initial signal line, respectively, and the fifth transistor is connected to the first power supply line and the light emitting signal line, respectively; and

an orthographic projection of the second electrode plate of the capacitor on the base substrate is at least partially overlapped with orthographic projections of the third scan signal line, the initial signal line, the first power supply line, the light emitting signal line, the first electrode plate of the capacitor, the first conductive region and the third conductive region on the base substrate.

9. The display substrate according to claim 8, wherein along the second direction, a distance between an orthographic projection of the gate electrode of the second transistor on the base substrate and an orthographic projection of the second electrode plate of the capacitor on the base substrate is less than a distance between the orthographic projection of the gate electrode of the second transistor on the base substrate and an orthographic projection of the gate electrode of the first transistor on the base substrate; and

a distance between an orthographic projection of the gate electrode of the fourth transistor on the base substrate and the orthographic projection of the second electrode plate of the capacitor on the base substrate is less than a distance between the orthographic projection of the gate electrode of the fourth transistor on the base substrate and an orthographic projection of the gate electrode of the fifth transistor on the base substrate.

10. The display substrate according to claim 8 or 9, wherein the second electrode plate of the capacitor is provided with a groove, and the groove exposes at least a portion of the first electrode plate of the capacitor, the first conductive region and the third conductive region.

11. The display substrate according to claim 10, wherein within a same sub-pixel, an opening direction of the groove is located on a side away from the second active layer.

12. The display substrate according to claim 10, wherein the second electrode plate of the capacitor comprises a capacitor main body portion, a first capacitor connection portion and a second capacitor connection portion, wherein the first capacitor connection portion and the second capacitor connection portion are located on two sides of the capacitor main body portion, respectively, and the groove is provided on a side of the capacitor main body portion;

the capacitor main body portion extends along the first direction, the first capacitor connection portion at least partially extends along the second direction, and the second capacitor connection portion extends along the second direction; and

an average length of the capacitor main body portions along the first direction is larger than an average length of the first capacitor connection portions along the first direction, and the average length of the first capacitor connection portions along the first direction is larger than an average length of the second capacitor connection portions along the first direction.

13. The display substrate according to claim 12, wherein an orthographic projection of the capacitor main body portion on the base substrate is at least partially overlapped with orthographic projections of the first electrode plate of the capacitor, the first conductive region and the third conductive region on the base substrate; and
orthographic projections of the first capacitor connection portion and the second capacitor connection portion on the base substrate are at least partially overlapped with orthographic projections of the first conductive region and the third conductive region on the base substrate, and are not overlapped with an orthographic projection of the first electrode plate of the capacitor on the base substrate.

14. The display substrate according to claim 10, wherein the first electrode plate of the capacitor comprises: a first region and a second region; the first region is a region exposed by the groove of the second electrode plate of the capacitor, and the second region is a region except the first region; and
an orthographic projection of the second electrode plate of the capacitor on the base substrate covers an orthographic projection of the second region of the first electrode plate of the capacitor on the base substrate.

15. The display substrate according to claim 8, wherein the first signal line further comprises: a reference signal line, a first scan signal line, and a second scan signal line; the second transistor is connected to the second scan signal line and the reference signal line, respectively, and the fourth transistor is connected to the first scan signal line; and
the reference signal line, the second scan signal line, the initial signal line, the third scan signal line, the light emitting signal line, the first power supply line and the first scan signal line are arranged sequentially along the first direction.

16. The display substrate according to claim 15, further comprising: a second signal line arranged on the base substrate, wherein the second signal line extends along the second direction, and comprises a data signal line; and
an orthographic projection of the data signal line on the base substrate is at least partially overlapped with orthographic projections of the first conductive region, the third conductive region, the fourth conductive region and the second electrode plate of the capacitor on the base substrate.

17. The display substrate according to claim 16, wherein the data signal line comprises: a data signal main body line and a plurality of data signal connection lines; the data signal main body line extends along the second direction, and the plurality of data signal connection lines extend along the first direction; and
an orthographic projection of the data signal main body line on the base substrate is at least partially overlapped with orthographic projection of the first conductive region, the third conductive region and the second electrode plate of the capacitor on the base substrate, and an orthographic projection of the data signal connection line on the base substrate is at least partially overlapped with an orthographic projection of the fourth conductive region on the base substrate.

18. The display substrate according to claim 17, further comprising: a driving structure layer arranged on the base substrate; wherein the driving structure layer comprises: a semiconductor layer, a first conductive layer, a second conductive layer, a third conductive layer and a fourth conductive layer which are stacked sequentially on the base substrate;

the semiconductor layer at least comprises: an active pattern of the first transistor, an active pattern of the second transistor, an active pattern of the third transistor, an active pattern of the fourth transistor, and an active pattern of the fifth transistor, which are located in at least one sub-pixel;
the first conductive layer at least comprises: a gate electrode of the first transistor, a gate electrode of the second transistor, a gate electrode of the third transistor, a gate electrode of the fourth transistor, a gate electrode of a fifth transistor and a first electrode plate of the capacitor, which are located in least one sub-pixel;
the second conductive layer at least comprises: a second electrode plate of the capacitance, which is located in at least one sub-pixel;
the third conductive layer at least comprises: a first scan signal line, a second scan signal line, a third scan signal line, a light emitting signal line, a reference signal line, a first power supply line, an initial signal line, and a second electrode of the first transistor, a second electrode of the second transistor, a second electrode of the third transistor and a first electrode and a second electrode of the fourth transistor, which are located in least one sub-pixel; and

27

the fourth conductive layer at least comprises: a data signal line.

19. The display substrate according to claim 18, wherein the driving structure layer further comprises: a first planarization layer and a fifth insulation layer that are located between the third conductive layer and the fourth conductive layer;

the fifth insulation layer is located on a side of the first planarization layer away from the base substrate; and a thickness of the first planarization layer is greater than a thickness of the fifth insulation layer.

20. The display substrate according to claim 19, wherein a thickness of the first planarization layer is 1.4 microns to 2.3 microns, and a thickness of the fifth insulation layer is 50 nanometers to 2500 nanometers.

21. The display substrate according to claim 18, wherein a thickness of the third conductive layer is greater than a thickness of the first conductive layer or a thickness of the second conductive layer; and a resistivity of the fourth conductive layer is smaller than a resistivity of the first conductive layer.

22. A display apparatus, comprising: the display substrate according to any one of claims 1 to 21.

FIG. 1

FIG. 2

FIG. 3

FIG. 4A

FIG. 4B

i-th column     (i+1)-th column       D1

D2

T2

REF

Gate2

INIT

Gate3

T1

T3

T5

EM

VDD

Gate1

Data       Data

T4

FIG. 5

31       34   33   32

30

27

26

25

20

24

23

22

21

10

210        220

FIG. 6

FIG. 7

FIG. 8

FIG. 9

FIG. 10

FIG. 11

FIG. 12

FIG. 13

i-th column | (i+1)-th column | D1

D2

C22

C2

K

C21

C23

## FIG. 14

i-th column | (i+1)-th column | D1

D2

## FIG. 15

i-th column | (i+1)-th column | D1
D2

V3
V8
V1
V7
V2
V4
V10
V6
V9
V5

## FIG. 16

i-th column | (i+1)-th column | D1
D2

T23

REF

Gate2

INIT          T13

Gate3

T14/
T34

T24/
T44

EM

VDD

Gate1

T43          T53

## FIG. 17

FIG. 18

FIG. 19

FIG. 20

i-th column | (i+1)-th column

D1

D2

FIG. 21

## INTERNATIONAL SEARCH REPORT

| International application No. |
| --- |
| **PCT/CN2023/090129** |

**A.    CLASSIFICATION OF SUBJECT MATTER**

H01L27/12(2006.01)i;  G09G3/3233(2016.01)i

According to International Patent Classification (IPC) or to both national classification and IPC

**B.    FIELDS SEARCHED**

Minimum documentation searched (classification system followed by classification symbols)

IPC: H01L, G09G

Documentation searched other than minimum documentation to the extent that such documents are included in the fields searched

Electronic data base consulted during the international search (name of data base and, where practicable, search terms used)

CNKI, CNTXT, ENTXTC, ENTXT, VEN, IEEE: 像素电路, 晶体管, 第二, 第一, 京东方, 连接, 一体, 有源, 栅电极, 栅极, 驱动, sub-pixel, pixel driving circuit, transistor, active, gate, drive

**C.    DOCUMENTS CONSIDERED TO BE RELEVANT**

| Category* | Citation of document, with indication, where appropriate, of the relevant passages | Relevant to claim No. |
| --- | --- | --- |
| A | CN 112435629 A (BOE TECHNOLOGY GROUP CO., LTD.) 02 March 2021 (2021-03-02) description, paragraphs [0070]-[0171], and figures 1-9 | 1-22 |
| A | CN 114335133 A (BOE TECHNOLOGY GROUP CO., LTD. et al.) 12 April 2022 (2022-04-12) entire document | 1-22 |
| A | CN 115705821 A (BOE TECHNOLOGY GROUP CO., LTD. et al.) 17 February 2023 (2023-02-17) entire document | 1-22 |
| A | US 2021280132 A1 (BOE TECHNOLOGY GROUP CO., LTD.) 09 September 2021 (2021-09-09) entire document | 1-22 |
| A | US 2022352296 A1 (CHENGDU BOE OPTOELECTRONICS TECHNOLOGY CO., LTD. et al.) 03 November 2022 (2022-11-03) entire document | 1-22 |

☑ Further documents are listed in the continuation of Box C.          ☑ See patent family annex.

| | |
| --- | --- |
| *      Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **20 June 2023** | **23 June 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/090129**

**C.    DOCUMENTS CONSIDERED TO BE RELEVANT**

| Category* | Citation of document, with indication, where appropriate, of the relevant passages | Relevant to claim No. |
|---|---|---|
| A | WO 2022057491 A1 (BOE TECHNOLOGY GROUP CO., LTD. et al.) 24 March 2022 (2022-03-24)<br>entire document | 1-22 |

Form PCT/ISA/210 (second sheet) (July 2022)

**INTERNATIONAL SEARCH REPORT**
Information on patent family members

International application No.

**PCT/CN2023/090129**

| Patent document cited in search report | | | Publication date (day/month/year) | Patent family member(s) | | | Publication date (day/month/year) |
|---|---|---|---|---|---|---|---|
| CN | 112435629 | A | 02 March 2021 | WO | 2022110650 | A1 | 02 June 2022 |
| CN | 114335133 | A | 12 April 2022 | None | | | |
| CN | 115705821 | A | 17 February 2023 | WO | 2023016341 | A1 | 16 February 2023 |
| US | 2021280132 | A1 | 09 September 2021 | US | 2022262310 | A1 | 18 August 2022 |
| | | | | US | 11348524 | B2 | 31 May 2022 |
| | | | | WO | 2019062579 | A1 | 04 April 2019 |
| | | | | CN | 109599062 | A | 09 April 2019 |
| | | | | KR | 20190131603 | A | 26 November 2019 |
| | | | | EP | 3690871 | A1 | 05 August 2020 |
| | | | | US | 2020273411 | A1 | 27 August 2020 |
| | | | | JP | 2020536264 | W | 10 December 2020 |
| | | | | EP | 3690871 | A4 | 19 May 2021 |
| | | | | KR | 20220031760 | A | 11 March 2022 |
| US | 2022352296 | A1 | 03 November 2022 | WO | 2022099549 | A1 | 19 May 2022 |
| | | | | WO | 2022099549 | A9 | 14 July 2022 |
| | | | | US | 11638385 | B2 | 25 April 2023 |
| | | | | DE | 112020007039 | T5 | 23 February 2023 |
| | | | | CN | 114902320 | A | 12 August 2022 |
| WO | 2022057491 | A1 | 24 March 2022 | US | 2023021680 | A1 | 26 January 2023 |
| | | | | CN | 112071882 | A | 24 March 2020 |

Form PCT/ISA/210 (patent family annex) (July 2022)